# EUROPEAN PATENT APPLICATION

(11) **EP 4 836 133 A1**
(43) Date of publication of application: **04.11.2026**
(21) Application number: 24910342.5
(22) Date of filing: 08.11.2024
(51) Int. Cl.: H01M 50/244, H01M 10/613

(54) **BATTERY PACK AND VEHICLE HAVING SAME**

(30) Priority: 29.12.2023 CN 202311869056
(71) Applicant: Zhejiang Geely Holding Group Co., Ltd., Hangzhou, Zhejiang 310051 (CN); Geely Automobile Research Institute (Ningbo) Co., Ltd., Ningbo, Zhejiang 315336 (CN)
(72) Inventor: CHEN, Boyan, Hangzhou, Zhejiang 310051 (CN); ZHAO, Qun, Hangzhou, Zhejiang 310051 (CN); ZHOU, Wei, Hangzhou, Zhejiang 310051 (CN); REN, Xiangfei, Hangzhou, Zhejiang 310051 (CN); GUO, Mengmeng, Hangzhou, Zhejiang 310051 (CN); ZHANG, Dewang, Hangzhou, Zhejiang 310051 (CN)
(74) Representative: Kraus & Lederer PartGmbB
(86) International application number: PCT/CN2024/130956
(87) International publication number: WO 2025/139405

(57) **Abstract**

Provided are a battery pack and a vehicle having same. The battery pack includes a frame, a partition assembly, a liquid cooling plate, and a bottom protection plate. The frame is configured to enclose a receiving cavity. The partition assembly is disposed in the frame to divide the receiving cavity into a plurality of receiving sub-cavities. The liquid cooling plate is located at a bottom of the frame, and has a bottom access opening directly facing one of the plurality of receiving sub-cavities. The liquid cooling plate is fixedly connected to the frame and at least part of the partition assembly adjacent to the bottom access opening. The bottom protection plate is detachably connected below the liquid cooling plate, and configured to open and close the bottom access opening.

## Description

### CROSS-REFERENCE TO RELATED APPLICATION

This application claims priority to Chinese Patent Application No. 202311869056.6, filed on December 29, 2023 and entitled "BATTERY PACK AND VEHICLE HAVING SAME", the entire disclosure of which are incorporated herein by reference.

### FIELD

The present disclosure relates to the field of battery pack technologies, and in particular, to a battery pack and a vehicle having the battery pack.

### BACKGROUND

With the iterative update of new energy technologies, the technology of battery-to-chassis integration continues to evolve. By directly integrating a battery pack into a chassis of a vehicle, a higher degree of integration can be achieved. The battery pack includes a frame, an upper cover, a battery group, an electrical connection component, and the like, with the electrical connection component mounted inside a casing.

Generally, a bottom of the battery pack is provided with a liquid cooling plate, and the liquid cooling plate of the battery pack is generally non-removable. When an electrical module inside the battery pack requires disassembly and maintenance, it can only be accessed from a side or top of the battery pack. In some solutions, an opening is formed in the liquid cooling plate to serve as a bottom access opening. However, a structure at this position tends to become loose during maintenance, which is not beneficial to maintaining a stable environment for long-term operation of the electrical module.

### SUMMARY

The present disclosure aims to solve at least one of the technical problems existing in the related art. To this end, the present disclosure provides a battery pack, which improves a supporting and protection effect on an electrical module by reasonably arranging fixed connection positions, thereby improving operation stability and reliability.

The present disclosure also aims to provide a vehicle having the above battery pack.

The battery pack according to an embodiment of the present disclosure includes a frame, a partition assembly, a liquid cooling plate, and a bottom protection plate. The frame is configured to enclose a receiving cavity. The partition assembly is disposed in the frame to divide the receiving cavity into a plurality of receiving sub-cavities. The liquid cooling plate is located at a bottom of the frame. The liquid cooling plate has a bottom access opening directly facing one of the plurality of receiving sub-cavities. The liquid cooling plate is fixedly connected to the frame and at least part of the partition assembly adjacent to the bottom access opening. The bottom protection plate is detachably connected below the liquid cooling plate. The bottom protection plate is configured to open and close the bottom access opening.

For the battery pack according to the embodiment of the present disclosure, the partition assembly is provided to divide the receiving cavity in the frame, separating the electrical module from the battery group. By forming the bottom access opening at the liquid cooling plate, at least part of the electrical module of the battery pack may be mounted above the bottom access opening, allowing a maintenance operation to be performed by opening the bottom access opening when required, thereby improving convenience of the maintenance operation for the battery pack. By forming a liquid inlet and a liquid outlet adjacent to the bottom access opening, a connection pipe needs to be connected above the liquid inlet and liquid outlet, and the at least part of the electrical module needs to be mounted above the bottom access opening, which allows for a compact layout of the space here without occupying other areas. Moreover, a vacant space above the liquid cooling plate may be used for arranging the battery group, which improves a space utilization rate of the area above the liquid cooling plate. A liquid cooling pipe connected here is disposed adjacent to the electrical module. A heat dissipation effect on the electrical module can be improved by utilizing the liquid cooling pipe. By fixedly connecting the liquid cooling plate to the frame and the partition assembly adjacent to the bottom access opening, an environment where the electrical module is located is relatively stable, and is not prone to loosening during long-term operation, improving stability and reliability of the operating environment.

A vehicle according to an embodiment of the present disclosure includes the above battery pack.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the description of embodiments taken in conjunction with the accompanying drawings, in which:
FIG. 1 is a schematic overall view of a battery pack according to some embodiments;
FIG. 2 is a schematic view of a positional relationship between an electrical module and a battery group from a viewing angle according to some embodiments;
FIG. 3 is a schematic view of a positional relationship between an electrical module and a battery group from another viewing angle according to some embodiments;
FIG. 4 is an exploded view of a battery pack from a viewing angle according to some embodiments;
FIG. 5 is a structural view of a battery pack with components and parts hidden from a viewing angle according to some embodiments;
FIG. 6 is a structural view of a battery pack with components and parts hidden from another viewing angle according to some embodiments;
FIG. 7 is a schematic structural view of a wiring harness of an electrical module according to some embodiments;
FIG. 8 is a schematic top view of an electrical module according to some embodiments;
FIG. 9 is a schematic front view of a partial structure of an electrical module according to some embodiments;
FIG. 10 is a schematic structural view of a battery pack with a side access cover open according to some embodiments;
FIG. 11 is a schematic view of a partial structure of a battery pack with a wiring harness hidden and a side access cover open according to some embodiments;
FIG. 12 is a schematic top view of partial structures of a casing and a support frame according to some embodiments;
FIG. 13 is a schematic top view of partial structures of a casing, a support frame, and a mounting plate according to some embodiments;
FIG. 14 is a schematic view of partial structures of a casing, a support frame, and a mounting plate from another viewing angle according to some embodiments;
FIG. 15 is a schematic rear view of structures of a casing and a support frame according to some embodiments;
FIG. 16 is a schematic view of an assembly structure of a BMS main control board from a viewing angle according to some embodiments;
FIG. 17 is a schematic view of an assembly structure of a BMS main control board from another viewing angle according to some embodiments;
FIG. 18 is a schematic view of an assembly structure of a BMS slave control board from a viewing angle according to some embodiments;
FIG. 19 is a schematic view of an assembly structure of a BMS slave control board from another viewing angle according to some embodiments;
FIG. 20 is a schematic structural view of a first BDU unit from a viewing angle according to some embodiments;
FIG. 21 is an exploded schematic view of a first BDU unit from another viewing angle according to some embodiments;
FIG. 22 is an exploded schematic view of a battery pack from yet another viewing angle according to some embodiments;
FIG. 23 is a partially enlarged view of FIG. 22;
FIG. 24 is a schematic structural view of a second electrical portion according to some embodiments;
FIG. 25 is an exploded view of a second electrical portion according to some embodiments;
FIG. 26 is a schematic structural view of a shock-absorbing post according to some embodiments;
FIG. 27 is a schematic view of a partial structure of a second electrical housing according to some embodiments;
FIG. 28 is a partial view of a seat fixing fastener assembled on an upper cover according to some embodiments;
FIG. 29 is a partially cross-sectional view of a seat fixing fastener assembled on an upper cover according to some embodiments;
FIG. 30 is a cross-sectional view of a casing of a battery pack according to some embodiments;
FIG. 31 is a cross-sectional view of a frame side beam and a mounting beam on a battery pack according to other embodiments;
FIG. 32 is a partial view of a casing of a battery pack according to other embodiments;
FIG. 33 is an exploded view of a casing of a battery pack according to other embodiments;
FIG. 34 is a perspective view of a liquid cooling plate according to some embodiments;
FIG. 35 is a bottom view of a liquid cooling plate according to some embodiments;
FIG. 36 is a schematic structural view of a bottom protection plate and a buffer layer on the bottom protection plate according to some embodiments of the present disclosure;
FIG. 37 is a schematic view of a partial structure of a bottom protection plate according to other embodiments of the present disclosure;
FIG. 38 is a schematic overall view of a vehicle according to some embodiments;
FIG. 39 is a positional relationship view of a battery pack in a vehicle body according to some embodiments.

Reference numerals:
vehicle 1000, battery pack 100, casing 1, frame 10, front side wall 11, rear side wall 12, middle segment 121, side segment 122, left side wall 13, right side wall 14, bottom protection plate 15, bottom main plate 150, thickened protruding rib 151, bottom edge strip 153, avoidance notch 1531, first bottom connection hole 156, second bottom connection hole 157, top cover 16, cover body 161, hard layer 161a, buffer layer 161b, mounting beam 17, first mounting beam 171, second mounting beam 172, mounting portion 17-10, mounting cavity 17-40, shock-absorbing layer 18, side access opening 101, external interface 102, frame side beam 10-1, frame body portion 10-10, connection rib 10-6, frame body cavity 10-40, first fixing hole 111, battery group 2, battery sub-group 20, battery cell 201, pressure relief member 202, first busbar 203, second busbar 204, electrical module 3, electrical connection structure 31, first wiring harness 311, first flexible wire 3111, first plug connector 3112, second flexible wire 3113, second plug connector 3114, third flexible wire 3115, third plug connector 3116, second wiring harness 312, second signal transmission interface 3121, third wiring harness 313, fourth wiring harness 314, high-voltage electrical terminal 315, low-voltage electrical terminal 316, copper busbar 317, first electrical portion 32, first BDU unit 321, first electrical housing 3211, first opening 3211a, second opening 3211b, first positioning protuberance 3211c, second threaded hole 3211d, first positioning cavity 3211e, second positioning protuberance 3211f, third threaded hole 3211g, second positioning cavity 3211h, fuse 3212, current sensor 3213, first plug interface 32131, first conductive sheet 3214, second conductive sheet 3215, top protection cover 3216, first through-hole 3216a, limiting slot 3216b, limiting protrusion 3216c, first snap-fit portion 3216d, side protection cover 3217, second snap-fit portion 3217a, arc-shaped plate 3217b, BMS main control board 322, second plug interface 3221, BMS slave control board 323, third plug interface 3231, mounting plate 324, flange 3241, mounting hole 3242, first bolt 3291, second bolt 3292, third bolt 3293, fourth bolt 3294, fifth bolt 3295, second electrical portion 33, fourth flexible wire 331, second electrical housing 332, shock-absorbing post 333, thick post segment 3331, thin post segment 3332, central hole 3333, first extension plate 3351, second extension plate 3352, engagement hook 33521, lower protrusion 336, second through-hole 3361, wire clamp 3362, main relay 337, electrical connection strip 338, first signal transmission interface 339, first snap-fit member 361, second snap-fit member 362, third snap-fit member 363, fourth snap-fit member 364, fifth snap-fit member 365, support frame 4, support longitudinal rod 40, first longitudinal rod 401, second longitudinal rod 402, third longitudinal rod 403, fourth longitudinal rod 404, support cross rod 41, first threaded hole 411, avoidance groove 412, partition assembly 5, partition beam 50, partition portion 50-10, partition cavity 50-40, partition cross beam 51, lower cross beam 511, upper cross beam 512, first notch 5131, second notch 5132, third notch 5133, first hanging hole 514, second hanging hole 515, partition longitudinal beam 52, fastening sleeve 53, connecting plate 54, receiving cavity V1, receiving sub-cavity V10, front sub-cavity V11, rear sub-cavity V12, flow passage V101, width of flow passage x1, liquid cooling plate 6, liquid flow channel 6-01, liquid inlet 6-02, liquid outlet 6-03, connector edge 6-04, upper liquid plate 6-05, lower liquid plate 6-06, welding through hole 6-061, first liquid cooling connection hole 6-07, second liquid cooling connection hole 6-08, first liquid cooling avoidance hole 6-09, second liquid cooling avoidance hole 6-10, branching sub-channel 6-11, return sub-channel 6-12, heat dissipation sub-channel 6-13, first extending sub-channel 6-14, second extending sub-channel 6-15, avoidance arcuate edge 6-16, liquid cooling pipe 601, liquid cooling connector 602, bottom access opening 61, fastening bolt 611, seal ring 62, bottom access cover 63, side access cover 64, air pressure balance valve 65, seat fixing fastener 66, seat fixing threaded hole 661, rotation platform 662, support circular platform 663, fixing plate 67, triangular reinforcement plate 68, insulation and heat-insulation cover 81, vehicle body 200, passenger space 220, upwardly recessed cavity 240, seat 300.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

In the description of the present disclosure, it should be noted that, unless expressly stated or limited otherwise, the terms "mounted", "connected", "coupled" shall be understood in a broad sense. For example, it may be a fixed connection, a detachable connection or an integral connection; it may be a mechanical connection or an electrical connection; it may be a direct connection or an indirect connection through an intermediate medium; it may also be internal communication between two elements. For those skilled in the art, the specific meaning of the above-mentioned terms in the embodiments of the present disclosure can be understood according to specific circumstances. In addition, features associated with "first" and "second" may include at least one or more such features, either explicitly or implicitly. In the description of the present disclosure, unless otherwise indicated, "plurality of" means two or more.

A battery pack 100 and various constituent structures of the battery pack 100 according to the embodiments of the present disclosure are described below with reference to the accompanying drawings.

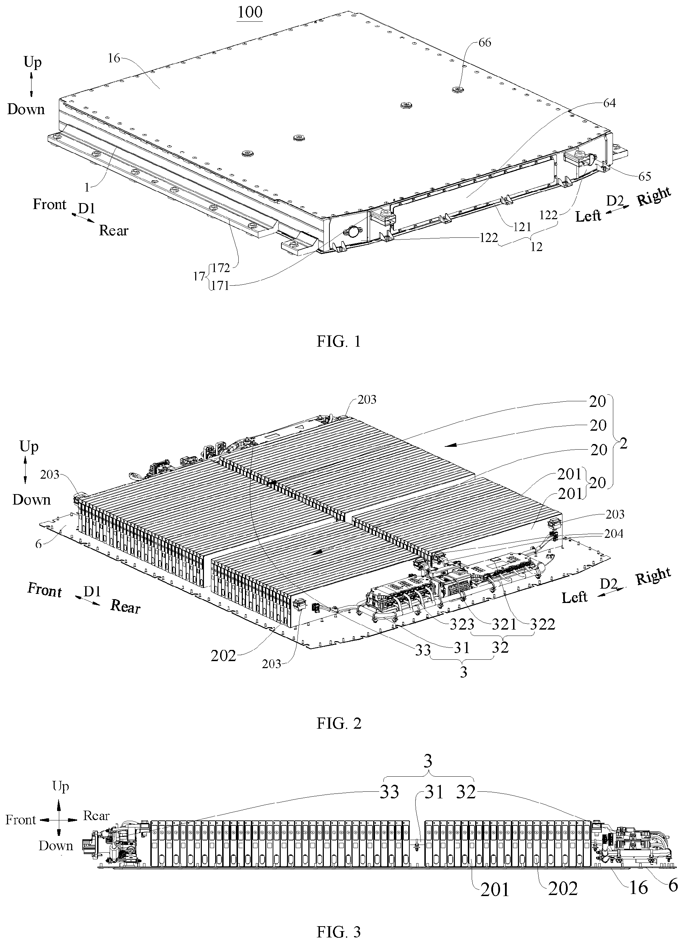

It can be understood that the application field of the battery pack 100 is not limited, and the battery pack 100 also has different mounting postures in different application scenarios. When the structure of the battery pack 100 is described herein, in embodiments not involving specific application scenarios, orientations or positional relationships indicated by terms "upper", "lower", "front", "rear", "left", "right", "top", "bottom", "longitudinal", "transverse", "length", "width", "thickness", "height", and the like are only for the convenience of describing the present disclosure and simplifying the description, rather than indicating or implying that the associated apparatus or element must have specific orientations and are constructed and operated in the specific orientations, and thus should not be construed to limit the present disclosure. In an embodiment of the present disclosure, as shown in FIG. 1 and FIG. 3, a first direction D1 is a front-rear direction, and a second direction D2 is a left-right direction. At this time, the battery pack 100 is horizontally arranged. Each of the first direction D1 and the second direction D2 is perpendicular to a height direction. A height direction of the battery pack 100 is an up-down direction shown in FIG. 1. With reference to this orientation, in the present disclosure, four side walls of a casing 1 are referred to as a front side wall 11, a rear side wall 12, a left side wall 13, and a right side wall 14, respectively. That is, the front side wall 11 and the rear side wall 12 are two opposite side walls of the casing 1 in the first direction D1, and the left side wall 13 and the right side wall 14 are two opposite side walls of the casing 1 in the second direction D2. In addition, a top cover 16 and a bottom protection plate 15 of the casing 1 are two opposite side walls of the casing 1 in the height direction. When the battery pack 100 is vertically arranged in another application scenario, the first direction D1 is adaptively adjusted to the up-down direction, and the height direction of the battery pack 100 is adaptively adjusted to a horizontal direction. At this time, names of the side walls of the casing 1 remain unchanged, but actual positions of the side walls in this application scenario should be adaptively adjusted. Similar scenarios are omitted below.

As shown in FIG. 1 to FIG. 6, the battery pack 100 according to an embodiment of the present disclosure includes a casing 1, a battery group 2, and an electrical module 3.

The casing 1 of the battery pack 100 includes a frame 10, a top cover 16, and a bottom protection plate 15. The frame 10 encloses a receiving cavity V1 of the casing 1. The top cover 16 and the bottom protection plate 15 are connected to upper and lower ends of the frame 10 to close the receiving cavity V1.

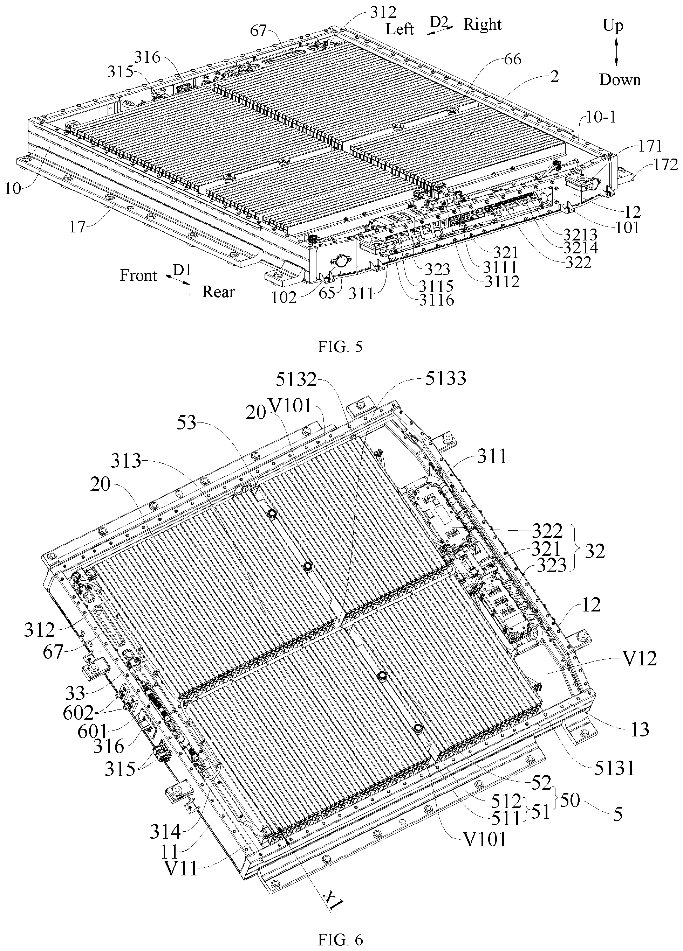

In some embodiments, as shown in FIG. 5, FIG. 6, FIG. 12, and FIG. 13, the battery pack 100 further includes a partition assembly 5 disposed in the casing 1. The casing 1 is internally provided with the partition assembly 5. The partition assembly 5 is disposed in the frame 10 to divide the receiving cavity V1 into a plurality of receiving sub-cavities V10. In this way, the battery group 2 and an electronic control structure can be separately arranged in different receiving sub-cavities V10.

The battery group 2 is located in the casing 1. The electrical module 3 is also mounted in the casing 1. The battery group 2 includes a plurality of battery cells 201. The plurality of battery cells 201 in the battery group 2 are connected in series or parallel to provide a required voltage and current.

The electrical module 3 includes an electrical connection structure 31 and an electronic control structure. The electronic control structure is configured to be responsible for energy control and management of the battery pack 100 to ensure safe operation of the battery pack 100. The electrical connection structure 31 is a connection conductor between the electronic control structure and various components in the battery pack 100.

In some embodiments, the electronic control structure is integrally formed to occupy a position in the battery pack 100. In other embodiments, the electronic control structure includes a first electrical portion 32 and a second electrical portion 33, i.e., the electronic control structure is separately formed to occupy different positions in the battery pack 100. The electrical connection structure 31 is configured to be electrically connected to the first electrical portion 32, the second electrical portion 33, and the battery group 2.

An electrical terminal of the electrical module 3 is configured to be electrically connected to an external environment for charging/discharging and to be in communication connection with the external environment. The electrical terminal further includes a high-voltage electrical terminal 315 and a low-voltage electrical terminal 316 that are disposed at the frame 10. The high-voltage electrical terminal 315 serves as both a charging terminal of the battery pack 100 for supplying power to the external environment and a charging terminal of the battery pack 100 itself during charging. The low-voltage electrical terminal 316 serves as an information terminal of the battery pack 100 for performing information communication with the external environment.

It should be noted here that in the present disclosure, the descriptions of "high voltage" and "low voltage" do not limit to specific voltages, but limit to relative voltage levels. A voltage of high-voltage electricity is usually a supply voltage of the battery pack 100 as a power source, while a voltage of low-voltage electricity is usually a signal transmission voltage in the battery pack 100.

In the related art, the electrical modules of the battery pack include a BDU (i.e., Battery Disconnect Unit) and a BMS (i.e., Battery Management System). The BDU realizes functions of high-voltage on-off and safety protection through control of the BMS. In practical applications, the electrical modules are concentrated at a side of the battery pack, and long busbars are provided to realize an electrical connection inside the battery pack. Moreover, the number of long busbars is at least three.

In the present disclosure, the electrical module 3 is divided into the first electrical portion 32 and the second electrical portion 33, which can reduce circuit connections running through the front and rear of the battery pack 100. Therefore, application costs of the electrical connections and a weight of the battery pack 100 can be reduced, and electrical layout in the battery pack 100 can be optimized.

With the battery pack 100 according to the embodiment of the present disclosure, by configuring the electrical module 3 as the first electrical portion 32 and the second electrical portion 33, the electrical layout in the battery pack 100 can be facilitated, and a spatial arrangement of the electrical module 3 inside the battery pack 100 can be optimized. In the related art, a space occupied by the electrical module in the battery pack is smaller than a space occupied by the battery group, and height dimensions of part of electrical modules are greater than a height dimension of the battery group. In order to receive the electrical module in the casing, it is necessary to increase a size of the casing, which also increases a size of the entire battery pack and reduces a utilization rate of an internal space of the battery pack. In the present disclosure, the optimized design can facilitate a reduction in the height of the electrical module 3, for example, making the height dimension of the battery group 2 greater than or equal to the height dimension of the electrical module 3, thus avoiding an increase in a size of the battery pack 100 caused by an excessively high height of the electrical module 3 and improving the utilization rate of the internal space of the battery pack 100. A height dimension of each component in the present disclosure refers to a dimension of the component in the height direction (i.e., the up-down direction indicated by D1 in FIG. 1).

In an embodiment of the present disclosure, the battery group 2, the first electrical portion 32, and the second electrical portion 33 are located in different receiving sub-cavities V10. Further, the battery group 2 includes a plurality of battery sub-groups 20, and each of the plurality of battery sub-groups 20 includes a plurality of battery cells 201. The plurality of battery sub-groups 20 are located in different receiving sub-cavities V10. The battery sub-groups 20, the first electrical portion 32, and the second electrical portion 33 are located in different receiving sub-cavities V10. In some solutions, the receiving sub-cavity V10 includes a front sub-cavity V11 configured to receive the second electrical portion 33 and a rear sub-cavity V12 configured to receive the first electrical portion 32.

In an embodiment of the present disclosure, a shape of the frame 10 usually determines an overall shape of the battery pack 100. The frame 10 may be a square frame, a hexagonal frame, or the like. A common frame 10 is in a quadrilateral shape. In an embodiment of the present disclosure, the frame 10 is formed by sequentially connecting a plurality of frame side beams 10-1, and each of the plurality of frame side beams 10-1 constitutes a side wall of the casing 1. When the frame 10 is in a rectangular shape, four sides of the rectangle frame 10 constitute the front side wall 11, the rear side wall 12, the left side wall 13, and the right side wall 14 of the casing 1. Further, the casing 1 further includes a mounting beam 17 connected to the frame 10. The mounting beam 17 may be mounted on the frame side beam 10-1. For example, the mounting beam 17 is mounted to each of the front side wall 11, the rear side wall 12, the left side wall 13, and the right side wall 14. Further, when the battery pack 100 is assembled, the frame side beam 10-1 of the frame 10 is connected to the top cover 16 and the bottom protection plate 15 by bolts to improve connection reliability.

In an embodiment of the present disclosure, during assembly, a top of the battery group 2 is directly adhesively connected to the top cover 16, allowing the top of the battery group 2 and the top cover 16 to be integrated inseparably. In another embodiment of the present disclosure, during assembly, a bottom of the battery group 2 is directly adhesively connected to the bottom protection plate 15, allowing the bottom of the battery group 2 and the bottom protection plate 15 to be integrated inseparably. Certainly, the solution of the present disclosure is not limited thereto. The bottom protection plate 15 may also be configured as a detachable connection structure to facilitate disassembly and maintenance of the battery pack 100 from the bottom. The top cover 16 may also be configured as a detachable connection structure to facilitate disassembly and maintenance of the battery pack 100 from the top. In some solutions, the top of the battery group 2 is not in direct contact with the top cover 16, but is spaced apart from the top cover 16 by an insulation and heat-insulation layer. The top of the battery group 2 and the top cover 16 are adhesively fixed through the insulation and heat-insulation layer, thus blocking upward heat transfer of the battery group 2.

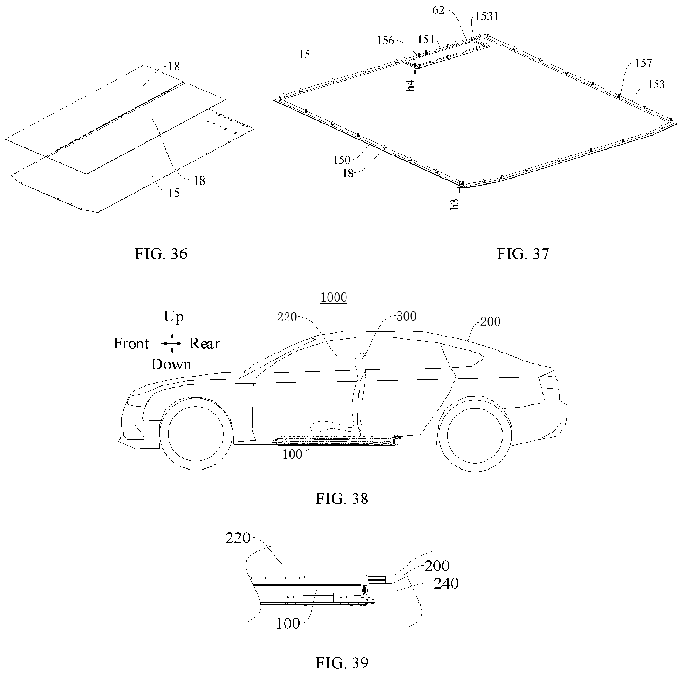

In some embodiments, a side access opening 101 is formed at the side wall of the casing 1, and the first electrical portion 32 is arranged facing the side access opening 101. For example, the side access opening 101 is formed at the rear side wall 12, and the first electrical portion 32 is located at a rear side of the battery group 2 and arranged facing the side access opening 101. The arrangement of the side access opening 101 may adapt to a shape of the vehicle 1000 when the battery pack 100 is applied in the vehicle 1000. When an upwardly recessed cavity 240 is formed at a bottom of the vehicle 1000 (as shown in FIG. 38 and FIG. 39), the side wall of the casing 1 is spaced apart from a side wall of the upwardly recessed cavity 240. As shown in FIG. 39, the upwardly recessed cavity 240 leaves a space behind the side access opening 101, allowing the first electrical portion 32 to be maintained by opening the side access opening 101 of the battery pack 100 from beneath the vehicle 1000.

In some embodiments, the second electrical portion 33 is located at a front side of the battery group 2.

In some embodiments, the frame 10 has a rear side wall 12. A rear sub-cavity V12 is defined in the frame 10 between the partition assembly 5 and the rear side wall 12. An electrical module 3 of the battery pack 100 includes a first electrical portion 32 mounted in the rear sub-cavity V12 and a second electrical portion 33 located above the bottom access opening 61. The rear side wall 12 has a side access opening 101 facing the first electrical portion 32.

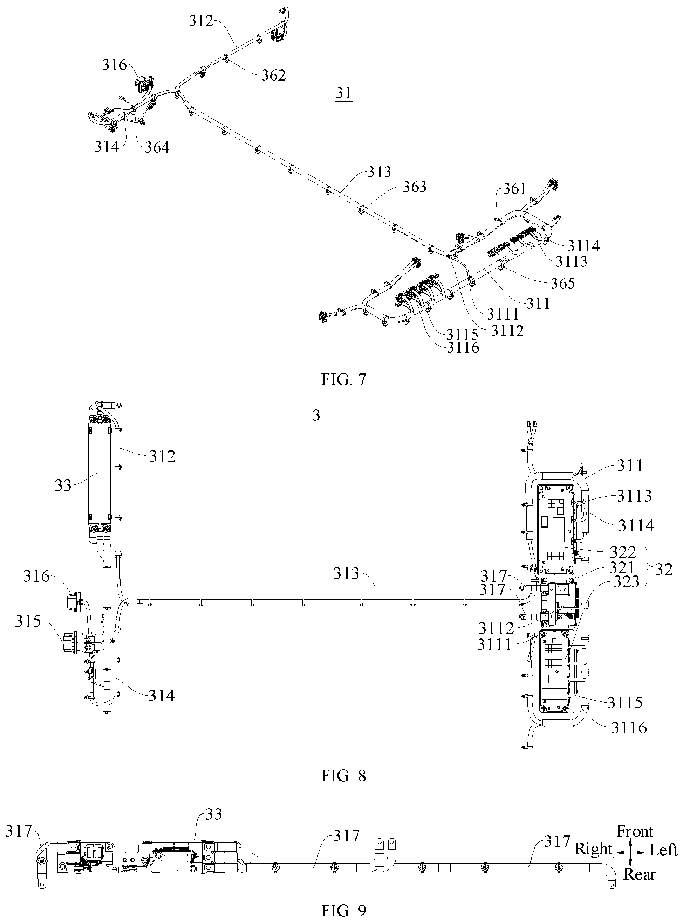

In some specific embodiments, as shown in FIG. 6 to FIG. 8, the first electrical portion 32 includes a BMS main control board 322 and a BMS slave control board 323 for signal control. In an embodiment of the present disclosure, the first electrical portion 32 further includes a first BDU unit 321 located between the BMS main control board 322 and the BMS slave control board 323. Further, as shown in FIG. 9, the second electrical portion 33 includes a second BDU unit.

In an embodiment of the present disclosure, the BMS main control board 322 and the BMS slave control board 323 realize the functions of high-voltage on-off and safety protection by cooperating with the first BDU unit 321 and the second BDU unit. The BMS main control board 322 is in communication connection with the BMS slave control board 323 through a wiring harness of the electrical connection structure 31. The BMS main control board 322 and the BMS slave control board 323 are in communication connection with the first BDU unit 321 and the second BDU unit through the wiring harness of the electrical connection structure 31. The first BDU unit 321 is located in a middle of the battery group 2 in the second direction D2. The second BDU unit is connected to the battery group 2 through a copper busbar 317. In the first electrical portion 32, the BMS main control board 322, the first BDU unit 321, and the BMS slave control board 323 are sequentially arranged in the second direction D2. The wiring harness part of the electrical connection structure 31 is shown in FIG. 7 and consists of a plurality of wiring harnesses.

By disposing the first BDU unit 321 between the BMS main control board 322 and the BMS slave control board 323, a central arrangement of the first BDU unit 321 is facilitated, which facilitates a symmetrical connection between the first BDU unit 321 and the battery group 2. When voltage division protection is required for the battery group 2, the first BDU unit 321 is symmetrical to two battery sub-groups 20 of the battery group 2, which facilitates voltage division balance.

In an embodiment of the present disclosure, the BMS main control board 322 and the BMS slave control board 323 are detachably disposed through the side access opening 101. It can be understood that in terms of failure frequency, the BMS main control board 322 and the BMS slave control board 323 both have higher failure rates. Therefore, the BMS main control board 322 and the BMS slave control board 323 are configured to be detachably connected to facilitate direct removal for maintenance and inspection in case of failure.

Exemplarily, the first electrical module 3 includes at least one BMS slave control board 323. The BMS slave control board 323 may collect and transmit battery cell data of the battery group 2, and transmit the data to the BMS main control board 322 through the electrical connection structure 31. Thus, the number of BMS slave control boards 323 can be set based on the number of battery cells 201 in the battery group 2.

In an embodiment of the present disclosure, two BMS slave control boards 32 are provided and stacked in the height direction. A dimension of each of the BMS slave control boards 323 in the first direction D1 is 86.5 mm, a dimension of each of the BMS slave control boards 323 in the second direction D2 is 240 mm, and a height dimension of each of the BMS slave control boards 323 is 19.7 mm. A stacked height of the two BMS slave control boards 323 is 48.7 mm. A dimension of the BMS main control board 322 in the first direction D1 is 102 mm, a dimension of the BMS main control board 322 in the second direction D2 is 260 mm, and a height dimension of the BMS main control board 322 is 24 mm. A dimension of the first BDU unit 321 in the first direction D1 is 103 mm, a dimension of the first BDU unit 321 in the second direction D2 is 153 mm, and a height dimension of the first BDU unit 321 is 85.5 mm. In the second direction D2, the dimensions of the BMS slave control board 323, the BMS main control board 322, and the first BDU unit 321 in the first electrical portion 321 are at least 653 mm.

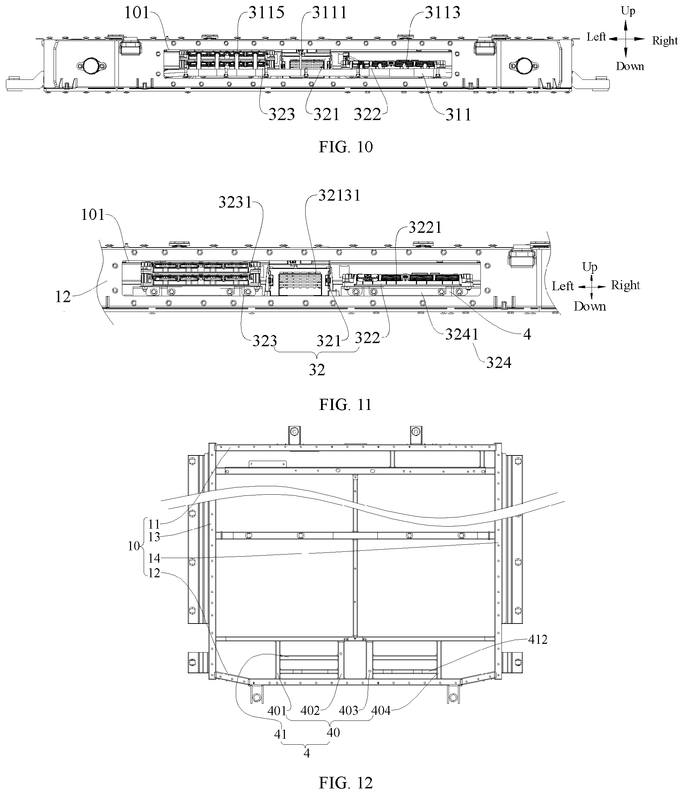

As shown in FIG. 10 and FIG. 11, a height dimension of each of the first electrical portion 321 and the second electrical portion 302 is lower than the height dimension of the battery group 2.

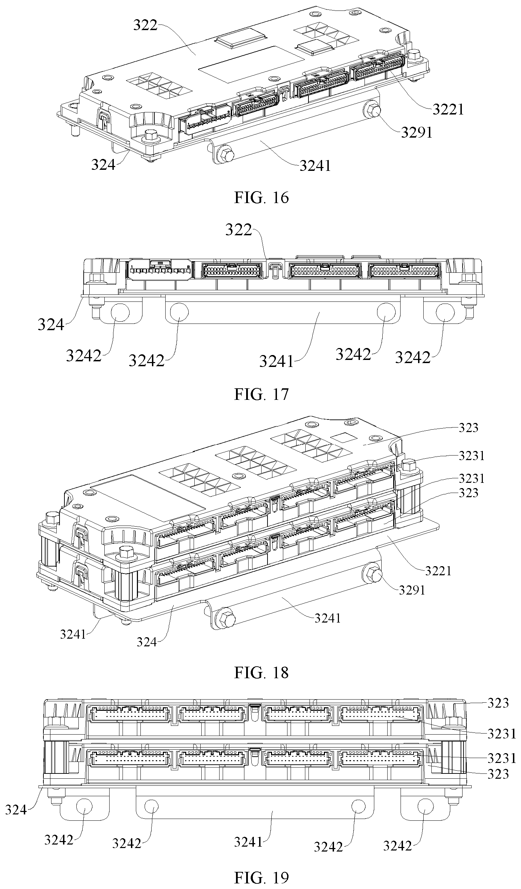

In some specific embodiments, as shown in FIG. 17, FIG. 18, and FIG. 11, the BMS slave control boards 323 are arranged in the left-right direction. At least two BMS slave control boards 323 are provided and stacked in the height direction. Projections of all the BMS slave control boards 323 on the rear side wall 12 completely are located within a coverage of the side access opening 101. In this way, the BMS slave control boards 323 can be directly pulled out or inserted in the horizontal direction during disassembly and assembly, reducing collisions caused by tilting. Moreover, when the side access opening 101 is open, states of the BMS slave control boards 323 can also be observed intuitively even without taking out the BMS slave control boards 323.

As shown in FIG. 18, FIG. 19, and FIG. 11, the BMS main control board 322 is arranged in the left-right direction, and a projection of the BMS main control board 322 on the rear side wall 12 is completely located within the coverage of the side access opening 101. In this way, the BMS main control board 322 can be directly pulled out or inserted in the horizontal direction during disassembly and assembly, reducing collisions caused by tilting. Moreover, when the side access opening 101 is open, a state of the BMS main control board 322 can also be observed intuitively even without taking out the BMS main control board 322.

In some embodiments, as shown in FIG. 12 to FIG. 14, the battery pack 100 further includes a support frame 4 located in the casing 1. The first electrical portion 32 is mounted at the support frame 4. The support frame 4 may provide the first electrical portion 32 with a supporting force, which reduces shaking of the first electrical portion 32 during a movement of the battery pack 100, thus improving safety of the battery pack 100. In addition, the arrangement of the support frame 4 can also lift the first electrical portion 32 to facilitate its alignment with the side access opening 101.

In an embodiment of the present disclosure, the support frame 4 is located in the rear sub-cavity V12 and connected to the rear side wall 12 and an adjacent partition cross beam 51 (described below). In an embodiment of the present disclosure, a front end and a rear end of the support frame 4 are connected to the partition cross beam 51 and the rear side wall 12 by bolts or welding, respectively.

A side of the support frame 4 facing the side access opening 101 has a plurality of first threaded holes 411 that are distributed sequentially in the second direction D2. The BMS main control board 322 and the BMS slave control board 323 may be directly or indirectly connected to the support frame 4 by bolts, and be connected to the first threaded holes 411 for easy disassembly and assembly.

In some embodiments, as shown in FIG. 16 to FIG. 19, the first electrical portion 32 includes two mounting plates 324. The BMS main control board 322 and the BMS slave control board 323 are mounted on their respective mounting plates 324, respectively. The mounting plates 324 are fixed in the casing 1 by first bolts 3291. Each of the first bolts 3291 is arranged in the front-rear direction and has a head located at its rear end. Projections of the first bolts 3291 on the rear side wall 12 are located within the coverage of the side access opening 101.

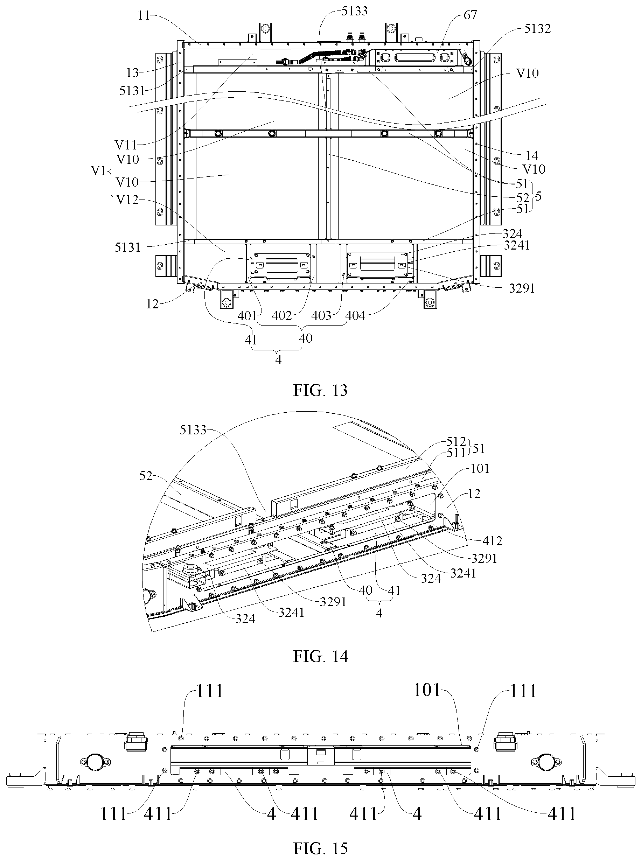

In an embodiment of the present disclosure, as shown in FIG. 16, the BMS main control board 322 is connected to one of the mounting plates 324, for example, is fixedly connected to the one mounting plate 324 by vertically arranged bolts. In an embodiment of the present disclosure, as shown in FIG. 18, the BMS slave control board 323 is connected to the other mounting plate 324, for example, is fixedly connected to the other mounting plate 324 by vertically arranged bolts. In an embodiment of the present disclosure, as shown in FIG. 13 and FIG. 14, during assembly, the mounting plate 324 with the BMS main control board 322 or the BMS slave control board 323 is placed at the support frame 4, and a side of the mounting plate 324 facing the side access opening 101 is formed with a downwardly extending flange 3241. As shown in FIG. 16 to FIG. 19, the flange 3241 has mounting holes 3242 corresponding to the first threaded holes 411, and the first bolts 34 pass through the mounting holes 3242 and the first threaded holes 411 sequentially for fixation.

As shown in FIG. 12 to FIG. 14, the support frame 4 includes four support cross rods 41 distributed in the first direction D1. Each support cross rod 41 extends in the second direction D2. Two of the support cross rods 41 are close to the side access opening 101, and the other two support cross rods 41 are away from the side access opening 101. Each support cross rod 41 has a first threaded hole 411 formed thereon. Moreover, each of the support cross rods 41 close to the side access opening 101 has an avoidance groove 412 corresponding to the first threaded hole 411 away from the side access opening 101.

The mounting plate 324 is provided with two flanges 3241 distributed in the first direction D1, and each flange 3241 has a mounting hole 3242 formed thereon. The mounting plate 324 is placed at the support frame 4, and has a downwardly extending flange 3241 formed at a side of the mounting plate 324 facing the side access opening 101. The flange 3241 has a mounting hole 3242 corresponding to the first threaded hole 411. The first bolt 34 may pass through the mounting hole 3242 and the first threaded hole 411 sequentially to realize fixation between the mounting plate 324 and the support frame 4. Moreover, the first bolt 34 is disposed at the support frame 4 in the second direction D2, which can reduce interference during disassembly and assembly and improve efficiency of mounting or disassembly. Moreover, the flange 3241 may also position mounting position of the mounting plate 324 and assist in the fixation between the mounting plate 324 and the support frame 4. The flange 3241 of the mounting plate 324 faces the side access opening 101 and extends downward. The flange 3241 is an integral long strip, and has a mounting hole 3242 formed at a position corresponding to the first threaded hole 411. Alternatively, the flange 3241 is a long strip having an avoidance groove 412, and is disposed at the position corresponding to the first threaded hole 411.

In some specific embodiments, as shown in FIG. 12 and FIG. 13, the support frame 4 further includes four support longitudinal rods 40. Each support longitudinal rod 40 extends in the first direction D1. The four support longitudinal rods 40 are a first longitudinal rod 401, a second longitudinal rod 402, a third longitudinal rod 403, and a fourth longitudinal rod 404 arranged sequentially. A support cross rod 41 is connected between the first longitudinal rod 401 and the second longitudinal rod 402. A support cross rod 41 is connected between the third longitudinal rod 403 and the fourth longitudinal rod 404.

The first electrical portion 32 includes two detachable components respectively located at the support cross rods 41 at the two sides. Thus, the support longitudinal rods 40 and the support cross rods 41 in the support frame 4 can support the detachable components. By configuring the support frame 4 as a combination of the support longitudinal rods 40 and the support cross rods 41, compared with configuring the support frame 4 as an integral support plate, on the one hand, the support longitudinal rods 40 are light in weight, which can reduce a weight of the entire battery pack 100 while meeting a structural strength. On the other hand, production and manufacturing processes of the support rods 40 are simple, which can reduce production costs and improve production efficiency. In an embodiment of the present disclosure, the two detachable components are the BMS main control board 322 and the BMS slave control board 323.

In an embodiment of the present disclosure, two support cross rod 41 is connected between the first longitudinal rod 401 and the second longitudinal rod 402, and are arranged in the first direction D1. Each support cross rod 41 has a mounting hole 3242 formed thereon. A support cross rod 41 close to the front in the first direction D1 is a first support cross rod, and a support cross rod 41 close to the rear in the first direction D1 is a second support cross rod. A height dimension of the second support cross rod is partially higher than a height dimension of the first support cross rod 41, and the mounting hole 3242 at the second support cross rod may be completely exposed. At the mounting hole 3242, the height dimensions of the first support cross rod and the second support cross rod are the same.

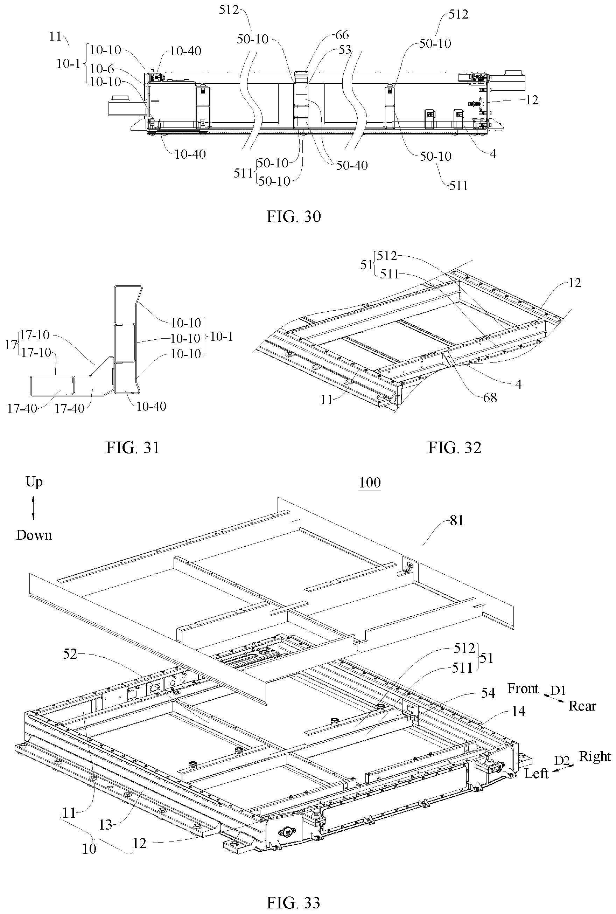

In some optional embodiments, as shown in FIG. 32, in order to improve support firmness of the support frame 4, the casing 1 further includes a triangular reinforcement plate 68. Two right-angled sides of the triangular reinforcement plate 68 are connected to the support frame 4 and an adjacent partition cross beam 51, respectively. By utilizing triangular stability of the triangle shape, support degrees and connection reliability of the support frame 4 and the adjacent partition cross beam 51 are improved. In an embodiment of the present disclosure, the triangular reinforcement plate 68 is connected to the support frame 4 through welding. In another embodiment of the present disclosure, the triangular reinforcement plate 68 is connected to the partition cross beam 51 through welding.

Further, the BMS slave control board 323 is detachably connected to the first longitudinal rod 401 and the second longitudinal rod 402 through one of the mounting plates 324, and the BMS main control board 322 is detachably connected to the third longitudinal rod 403 and the fourth longitudinal rod 404 through the other mounting plate 324. The support longitudinal rods 40 at the end are used to connect the BMS main control board 322 or the BMS slave control board 323. On the one hand, positioning is facilitated. On the other hand, the connection length in the first direction D1 is increased.

Further, the first BDU unit 321 may be mounted at the second longitudinal rod 402 and the third longitudinal rod 403. For example, the first BDU unit 321 includes a first electrical housing 3011 connected to the second longitudinal rod 402 and the third longitudinal rod 403 through vertically arranged bolts.

In some embodiments, as shown in FIG. 10, FIG. 20, and FIG. 21, the first BDU unit 321 includes a first electrical housing 3211 and a fuse 3212. The first electrical housing 3211 has a first opening 3211a formed at a rear side of the first electrical housing 3211. The fuse 3212 is detachably disposed in the first electrical housing 3211. In an embodiment of the present disclosure, the fuse 3013 is detachably connected to the first electrical housing 3011. After the electrical connection is cut off when the battery pack 100 fails, the fuse 3013 needs to be replaced or manually reset.

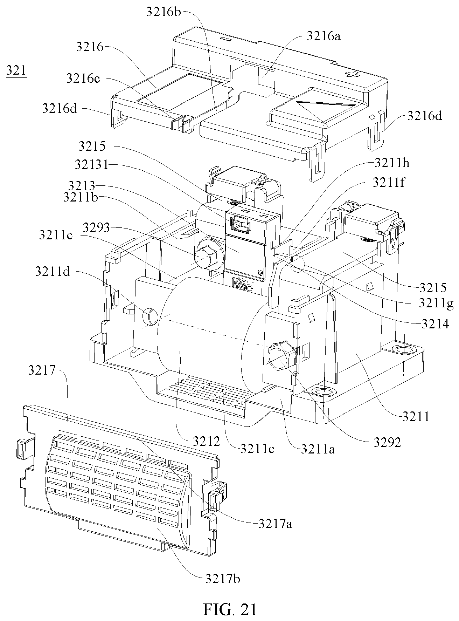

In an embodiment of the present disclosure, the first BDU unit 321 further includes a side protection cover 3217 detachably covering the first opening 3211a. By providing the first electrical housing 3211 and the side protection cover 3217, on the one hand, internal electrical components of the first BDU unit 321, such as the fuse 3212, can be protected. On the other hand, the internal electrical components, such as the fuse 3212, are disposed in the first electrical housing 3211, which realizes fixation and mounting of the internal electrical components and improves convenience and reliability of the fixed connection. Further, as shown in FIG. 21, each of two ends of the side protection cover 3217 is provided with a second snap-fit portion 3217a. The side protection cover 3217 may be in a snap-fit connection with the first electrical housing 3211 through the second snap-fit portions 3217a.

In some specific embodiments, as shown in FIG. 21, the side protection cover 3217 includes an arc-shaped plate 3217b located between the second snap-fit portions 3217a at the two sides of the side protection cover 3217, and has a shape matching the fuse 3212, which improves compactness and constraint on the fuse 3212. The arc-shaped plate 3217b may be a circular arc plate. In an embodiment of the present disclosure, the arc-shaped plate 3217b is a grid plate to improve a heat dissipation effect. By providing the second snap-fit portions 3217a for connection, connection stability and convenience are improved. By configuring the side protection cover 3217 as a circular arc grid plate, a structural strength of the side protection cover 3217 can be improved.

In an embodiment of the present disclosure, the first BDU unit 321 further includes a current sensor 3213 connected in series with the fuse 3212 and detachably disposed in the first electrical housing 3211. In this way, the current sensor 3213 can timely detect a current passing through the fuse 3212, enabling the BMS slave control board 323 to timely determine whether the fuse 3212 needs to be blown.

Internal circuit structures and specific working principles of the fuse 3212, the current sensor 3213, the BMS main control board 322, and the BMS slave control board 323 are each related art, and are omitted here.

In an embodiment of the present disclosure, as shown in FIG. 21, the fuse 3212 is fixed on the first electrical housing 3211 by a second bolt 3292. A head of the second bolt 3292 directly faces the side access opening 101. A projection of the second bolt 3292 on the rear side wall 12 is located within the coverage of the side access opening 101. Thus, reliability and stability of the connection of the fuse 3212 to the first electrical housing 1 are improved.

When the fuse 3212 fails and needs to be replaced, the second snap-fit portion 3217a is unlocked to separate the side protection cover 3217 from the first electrical housing 3211 to expose the second bolt 3292. Then, the second bolt 3292 is unscrewed to release the fixed connection between the fuse 3212 and the first electrical housing 3211. Finally, the faulty fuse 3212 is taken out through the side access opening 101.

Similarly, the current sensor 3213 is fixed on the first electrical housing 3211 by a third bolt 3293. A head of the third bolt 3293 is arranged facing the side access opening 101. A projection of the third bolt 3293 on the rear side wall 12 is located within the coverage of the side access opening 101. Thus, reliability and stability of the connection of the current sensor 3213 to the first electrical housing 1 are improved.

When the current sensor 3213 fails and needs to be replaced, the second snap-fit portion 3217a is unlocked to separate the side protection cover 3217 from the first electrical housing 3211 to expose the third bolt 3293. Then, the third bolt 3293 is unscrewed to release the fixed connection between the current sensor 3213 and the first electrical housing 3211. Finally, the faulty current sensor 3213 is taken out through the side access opening 101.

In some embodiments, as shown in FIG. 21, the first electrical housing 3211 is internally provided with a first positioning cavity 3211e opened towards the side access opening 101, and a second positioning cavity 3211h. The fuse 3212 is located in the first positioning cavity 3211e. The current sensor 3213 is located in the second positioning cavity 3211h. In this way, the first positioning cavity 3211e and the second positioning cavity 3211h are used to respectively position the fuse 3212 and the current sensor 3213, facilitating assembly.

In an embodiment of the present disclosure, the first electrical housing 3211 is internally formed with a first positioning protuberance 3211c on at least one side of the first positioning cavity 3211e, and an end of the fuse 3212 is detachably connected to the first positioning protuberance 3211c. The fuse 3212 is fixedly connected at a side of the first positioning cavity 3211e, which causes less obstruction to the fuse 3212.

The first electrical housing 3211 is internally formed with a second positioning protuberance 3211f on at least one side of the second positioning cavity 3211h, and an end of the current sensor 3213 is detachably connected to the second positioning protuberance 3211f. The current sensor 3213 is fixedly connected at the side of the second positioning cavity 3211h, which causes less obstruction to the current sensor 3213.

Further, a threaded hole is formed at each of a surface of the first positioning protuberance 3211c facing the side access opening 101 and a surface of the second positioning protuberance 3211f facing the side access opening 101. The fuse 3212 is connected to the first positioning protuberance 3211c by bolts. The current sensor 3213 is connected to the second positioning protuberance 3211f by bolts. The bolt connection is convenient and fast, and does not affect the line of sight.

In some specific embodiments, as shown in FIG. 21, the first electrical housing 3211 is internally provided with two first positioning protuberances 3211c. A rear surface of each of the first positioning protuberances 3211c has a second threaded hole 3211d. The first positioning cavity 3211e is defined between the two first positioning protuberances 3211c. The fuse 3212 is located in the first positioning cavity 3211e. Two ends of the fuse 3212 are connected to the two first positioning protuberances 3211c through the second bolts 3292. Each second bolt 3292 is threadedly engaged with the corresponding second threaded hole 3211d.

The first electrical housing 3211 is provided with two second positioning protuberances 3211f. A rear surface of each of the two second positioning protuberances 3211f has a third threaded hole 3211g. The second positioning cavity 3211h is defined between the two second positioning protuberances 3211f. The current sensor 3213 is located in the second positioning cavity 3211h. Two ends of the current sensor 3213 are connected to the two second positioning protuberances 3211f through the third bolts 3293. Each third bolt 3293 is threadedly engaged in the corresponding third threaded hole 3211g.

In this way, both the fuse 3212 and the current sensor 3213 are accurately positioned, and it is helpful to structure compactness.

In an embodiment of the present disclosure, the first positioning protuberance 3211c and the second positioning protuberance 3211f are staggered in height and are at different distances from the side access opening 101.

Further, the two first positioning protuberances 3211c are arranged in the left-right direction, and the two second positioning protuberances 3211f are arranged in the left-right direction. The two second positioning protuberances 3211f and the two first positioning protuberances 3211c are different in height. Moreover, the rear surface of the first positioning protuberance 3211c and the rear surface of the second positioning protuberance 3211f are staggered in the front-rear direction. This arrangement is intended to provide front-rear staggering of the fuse 3212 and the current sensor 3213 during disassembly and assembly, which is beneficial to a reduction in the dimensions of the first BDU unit 321 in the height direction and the front-rear direction.

In an embodiment of the present disclosure, the first positioning protuberance 3211c is located below the second positioning protuberance 3211f, so that the fuse 3212 is mounted below the current sensor 3213. In addition, the fuse 3212 is located at a rear side of the current sensor 3213, and closer to the side access opening 101. In terms of failure frequency, this arrangement makes a fuse 3212 having a higher failure rate easier to remove.

Advantageously, as shown in FIG. 21, the first BDU unit 321 further includes a first conductive sheet 3214 located in the first positioning cavity 3211e and located at a side of the fuse 3212 away from the side access opening 101. One of two ends of the first conductive sheet 3214 is pressed against the side of the fuse 3212 away from the side access opening 101, and another one of the two ends of the first conductive sheet 3214 is pressed against a side of the current sensor 3213 away from the side access opening 101. In this way, the first conductive sheet 3214 not only connects the fuse 3212 and the current sensor 3213 in series, but also does not affect observation and disassembly of the fuse 3212 and the current sensor 3213 from the side access opening 101.

In some specific embodiments, as shown in FIG. 21, the first BDU unit 321 further includes a first conductive sheet 3214 located in the first positioning cavity 3211e and at a front side of the fuse 3212. One of the second positioning protuberances 3211f is located directly above corresponding one of the first positioning protuberances 3211c, and a dimension of the current sensor 3213 in the left-right direction is smaller than a dimension of the fuse 3212 in the left-right direction. A part of a side edge of the first conductive sheet 3214 extends laterally and then is bent to be connected to the one first positioning protuberance 3211c for electrical connection with the fuse 3212. A part of an upper edge of the first conductive sheet 3214 extends upward and then is bent to be connected to the other second positioning protuberance 3211f for electrical connection with the current sensor 3213.

This arrangement uses the first conductive sheet 3214 to connect the fuse 3212 and the current sensor 3213 in series. Moreover, the first conductive sheet 3214 is not easy to disengage, with high reliability. A width of the first conductive sheet 3214 may be set to be relatively large, which is beneficial to a reduction in resistance and the like.

In an embodiment of the present disclosure, as shown in FIG. 21, the first electrical housing 3211 has a second opening 3211b at a top of the first electrical housing 3211. The first BDU unit 321 further includes a top protection cover 3216 and two second conductive sheets 3215. The two second conductive sheets 3215 are spaced apart from each other and disposed at the top of the first electrical housing 3211 in the left-right direction, and each second conductive sheet 3215 extends in the front-rear direction.

A rear end of one of the second conductive sheets 3215 is bent downward to rest on one of the first positioning protuberances 3211c to be electrically connected to the fuse 3212. A rear end of the other second conductive sheet 3215 is bent downward to rest on one of the second positioning protuberances 3211f to be electrically connected to the current sensor 3213. Front ends of the two second conductive sheets 3215 are connected to the battery group 2 through the copper busbar 317. The top protection cover 3216 is detachably connected to the top of the first electrical housing 3211 and covers the two second conductive sheets 3215.

The arrangement of the top protection cover 3216 not only facilitates disassembly, assembly, and maintenance, but also provides a certain degree of position constraint on the second conductive sheets 3215. This arrangement results in high electrical reliability and more flexible component replacement.

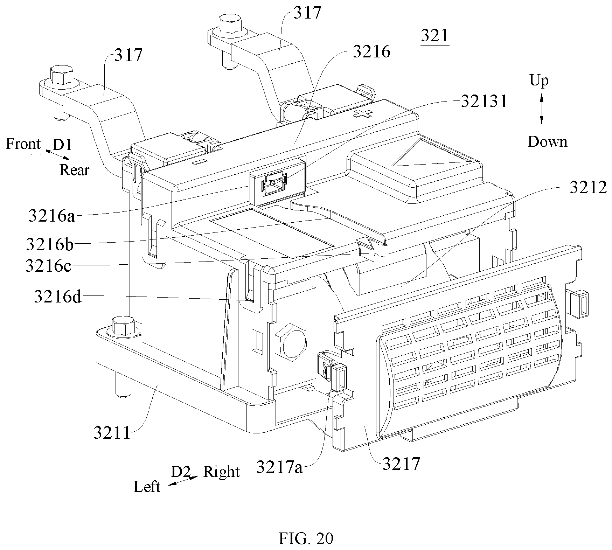

In an embodiment of the present disclosure, as shown in FIG. 20 and FIG. 21, the current sensor 3213 has a first plug interface 32131 at the rear side of the current sensor 3213, and the top protection cover 3216 has a first through-hole 3216a directly facing the first plug interface 32131.

As shown in FIG. 7 and FIG. 8, the electrical connection structure 31 includes a first flexible wire 3111 located at a rear side of the first BDU unit 321. An end of the first flexible wire 3111 is provided with a first plug connector 3112. The first plug connector 3112 is inserted and engaged in the first plug interface 32131 through the first through-hole 3216a.

In this way, during disassembly and assembly, the first plug connector 3112 can be directly unplugged from the side access opening 101. The first flexible wire 3111 is pulled aside, and then an internal structure of the first BDU unit 321 is inspected or disassembled and assembled. After the assembly is completed, the first plug connector 3112 is directly inserted from the rear side, making the assembly very convenient and reducing interference of messy wires.

In an embodiment of the present disclosure, as shown in FIG. 20 and FIG. 21, a top surface of the top protection cover 3216 has a limiting slot 3216b extending in the front-rear direction. A front end of the limiting slot 3216b is arranged facing the first through-hole 3216a, and a part of the first flexible wire 3111 is located in the limiting slot 3216b. The limiting slot 3216b can realize constraint on the first flexible wire 3111, and reduce shaking of the first flexible wire 3111 during vibration and a probability of loosening caused by shaking. Moreover, compared with other wires, the first flexible wire 3111 is thinner and lighter in weight, which can improve connection reliability and thus enhance the safety of the battery pack 100 during use.

In an embodiment of the present disclosure, the top protection cover 3216 is further provided with a limiting protrusion 3216c on at least one side of the limiting slot 3216b, which can further constrain the first flexible wire 3111 and improve safety of the first flexible wire 3111 during use. Further, as shown in FIG. 21, the top protection cover 3216 is provided with two limiting protrusions 3216c having barbs at their ends, to facilitate hooking the first flexible wire 3111.

Further, as shown in FIG. 21, each of two ends of the top protection cover 3216 is provided with a first snap-fit portion 3216d. The top protection cover 3216 may be in a snap-fit connection with the first electrical housing 3211 through the first snap-fit portion 3216d. By providing the first snap-fit portion 3216d for connection, connection stability and convenience are improved.

In some embodiments, as shown in FIG. 7, FIG. 8, and FIG. 10, the BMS main control board 322 has a second plug interface 3221 at a rear side of the BMS main control board 322, and the BMS slave control board 323 has a third plug interface 3231 at a rear side of the BMS slave control board 323. The electrical connection structure 31 further includes a second flexible wire 3113 located at the rear side of the BMS main control board 322. An end of the second flexible wire 3113 is provided with a second plug connector 3114 engaged into the second plug interface 3221.

The electrical connection structure 31 further includes a third flexible wire 3115 located at the rear side of the BMS slave control board 323. An end of the third flexible wire 3115 is provided with a third plug connector 3116 engaged into the third plug interface 3231.

This arrangement can allow the second plug connector 3114 and the third plug connector 3116 to be directly unplugged from the side access opening 101 during disassembly and assembly. The second flexible wire 3113 is pulled aside, enabling a structure of the BMS main control board 322 to be inspected or disassembled and assembled. The third flexible wire 3115 is pulled aside, enabling a structure of the BMS slave control board 323 to be inspected or disassembled and assembled.

After assembly is completed, the second plug connector 3114 and the third plug connector 3116 are directly inserted from the rear side, making the assembly very convenient and reducing the interference of messy wires.

As shown in FIG. 6 and FIG. 8, in some embodiments, the electrical connection structure 31 includes a first wiring harness 311 arranged around the first electrical portion 32 and electrically connected to the battery group 2. The first wiring harness 311 is provided with plug connectors that are inserted into and connected with the BMS main control board 302, the BMS slave control board 303, and the first BDU unit 321, respectively. The plug connectors are located at a side of the first electrical portion 32 facing the side access opening 101. The first wiring harness 311 is arranged around the first electrical portion 32, which can change insertion directions of the plug connectors on the first wiring harness 311 to face the side access opening 101. Thus, the first wiring harness 311 can be more easily pulled aside through the side access opening 101, further improving maintenance convenience.

In an embodiment of the present disclosure, the first flexible wire 3111, the second flexible wire 3113, and the third flexible wire 3115 are each led out from the first wiring harness 311.

In an embodiment of the present disclosure, the first wiring harness 311 is provided with a plurality of wiring harness snaps arranged at intervals in an extending direction of the first wiring harness 311, and a disassembly and assembly direction of the wiring harness snaps faces the side access opening 101. The first wiring harness 311 can be fixed by the plurality of wiring harness snaps, reducing swing of the first wiring harness 311 and a probability of loosening the insertion of the plug connectors on the first wiring harness 311.

In some embodiments, as shown in FIG. 1 and FIG. 3, the battery pack 100 further includes a side access cover 64. The side access cover 64 may cover the side access opening 101, and is openably and closably connected to the rear side wall 12. The side access cover 64 can protect the internal structure of the battery pack 100, preventing dust, moisture, and the like from entering the battery pack 100 through the side access opening 101.

In an embodiment of the present disclosure, as shown in FIG. 15, the rear side wall 12 has a plurality of first fixing holes 111 arranged at intervals in a circumferential direction of the side access opening 101. The side access cover 64 may cover the side access opening 101, and has a plurality of through holes corresponding to positions of the first fixing holes 111. The first fixing holes 111 and the through holes are connected by fasteners to improve connection stability.

Alternatively, the side access cover 64 is connected to the rear side wall 12. A side edge of the side access cover 64 may be rotated with respect to the rear side wall 12, and other side edges of the side access cover 64 have through holes corresponding to the fixing holes of the rear side wall 12. The through holes and the fixing holes are connected by the fasteners.

In an embodiment of the present disclosure, a dimension of the side access opening 101 in the second direction D2 is 720 mm, and a height dimension of the side access opening 101 is 70 mm. A height dimension of the first electrical portion 32 is smaller than the height dimension of the side access opening 101. Thus, the BMS main control board 322, the BMS slave control boards 323, and the first BDU unit 321 in the first electrical portion 32 can pass through the side access opening 101, respectively.

In an embodiment of the present disclosure, when one of the BMS main control board 322, the BMS slave control board 323, and the first BDU unit 321 needs to be replaced, the fasteners in the first fixing holes 111 are released, and the side access cover 64 is removed. Moreover, the wiring harness snaps 91 may be disassembled one by one through the first access opening 12. The plug connectors are removed, and the faulty electrical component is removed through the side access opening 101.

In some embodiments, as shown in FIG. 7 and FIG. 8, the electrical connection structure 31 includes a second wiring harness 312, a third wiring harness 313, and a fourth wiring harness 314. The second wiring harness 312 is arranged in a length direction of the second electrical portion 33, and is detachably connected to at least one end of the second electrical portion 33, which allows the electrical connection structure 31 to be electrically connected to the second electrical portion 33.

The third wiring harness 313 is connected between the first wiring harness 311 and the second wiring harness 312, which allows for communication between the first electrical portion 32 and the second electrical portion 33. The fourth wiring harness 314 is connected to the third wiring harness 313, and an end of the fourth wiring harness 314 is provided with a low-voltage electrical terminal 316. Through the low-voltage electrical terminal 316 of the fourth wiring harness 314, the battery pack 100 can perform signal transmission with devices outside the battery pack 100.

In some embodiments, in order to reduce shaking of the electrical connection structure 31 in the battery pack 100, a plurality of snap-fit members can be provided to constrain the wiring harnesses.

In an embodiment of the present disclosure, as shown in FIG. 7, a first snap-fit member 361 may be provided to constrain the first wiring harness 311. For example, the first wiring harness 311 may be bound to a partition cross beam 51. A second snap-fit member 362 may be provided to constrain the second wiring harness 312. For example, the second wiring harness 312 may be bound to a partition longitudinal beam 52. A third snap-fit member 363 may be provided to constrain the third wiring harness 313. For example, the third wiring harness 314 may be bound to a partition cross beam 51.

In an embodiment of the present disclosure, a fourth snap-fit member 364 may be further provided to constrain the fourth wiring harness 314. For example, the fourth wiring harness 314 may be bound to a partition cross beam 51. In an embodiment of the present disclosure, a fifth snap-fit member 365 may be provided to constrain the first wiring harness 311. The first snap-fit member 361 is located at a front side of the first electrical portion 32. The fifth snap-fit member 365 is located at a rear side of the first electrical portion 32. For example, the fifth snap-fit member 365 may be clamped at the support frame 4 or the rear side wall 12.

In some embodiments, as shown in FIG. 13 and FIG. 6, the partition assembly 5 includes at least one partition beam 50, for example, may include at least one partition cross beam 51 or at least one partition longitudinal beam 52, configured to cooperate with the frame 10 to divide the receiving cavity V1 into a plurality of receiving sub-cavities V10. Each partition cross beam 51 extends in the left-right direction, and each partition longitudinal beam 52 extends in the front-rear direction.

In some specific embodiments, as shown in FIG. 3 and FIG. 14, the partition assembly 5 includes at least three partition cross beams 51 extending in the left-right direction. The at least three partition cross beams 51 are arranged at intervals in the front-rear direction.

In some specific embodiments, as shown in FIG. 3 and FIG. 14, the partition assembly 5 includes at least two partition cross beams 51 each extending in the left-right direction. Two adjacent partition cross beams 51 of the at least two partition cross beams 51 are spaced apart from each other in the front-rear direction.

The battery group 2 is located between a foremost partition cross beam 51 and a rearmost partition cross beam 51. The front sub-cavity V11 is defined between the foremost partition cross beam 51 and the front side wall 11, and the second electrical portion 33 is located in the front sub-cavity V11. The rear sub-cavity V12 is defined between the rearmost partition cross beam 51 and the rear side wall 12, and the first electrical portion 32 is located in the rear sub-cavity V12.

The at least three partition cross beams 51 are arranged to divide the interior of the casing 1 of the battery pack 100 into regions, which not only improves the structural strength of the battery pack 100, but also provides a mounting position for the internal structure. In addition, the arrangement of the at least three partition cross beams 51 can also limit a discharge direction of internal fluid.

The partition assembly 5 further includes the partition longitudinal beam 52. In an embodiment of the present disclosure, the partition assembly 5 further includes at least two partition longitudinal beams 52 extending in the front-rear direction. One of the partition longitudinal beams 52 is connected between every two adjacent partition cross beams 51, to divide a space between the two adjacent partition cross beams 51 into two receiving sub-cavities V10. One of the receiving sub-cavities V10 is defined by two adjacent partition cross beams 51, one of the partition longitudinal beams 52, and the side wall of the casing 1. The battery group 2 includes a plurality of battery sub-groups 20. One of the battery sub-groups 20 is received in each receiving sub-cavity V10.

In some specific embodiments, the frame 10 includes a left side wall 13 and a right side wall 14. The battery group 2 of the battery pack 100 includes a plurality of battery sub-groups 20. The battery sub-group 20 is distributed in the receiving sub-cavity V10 located between the two partition cross beams 51.

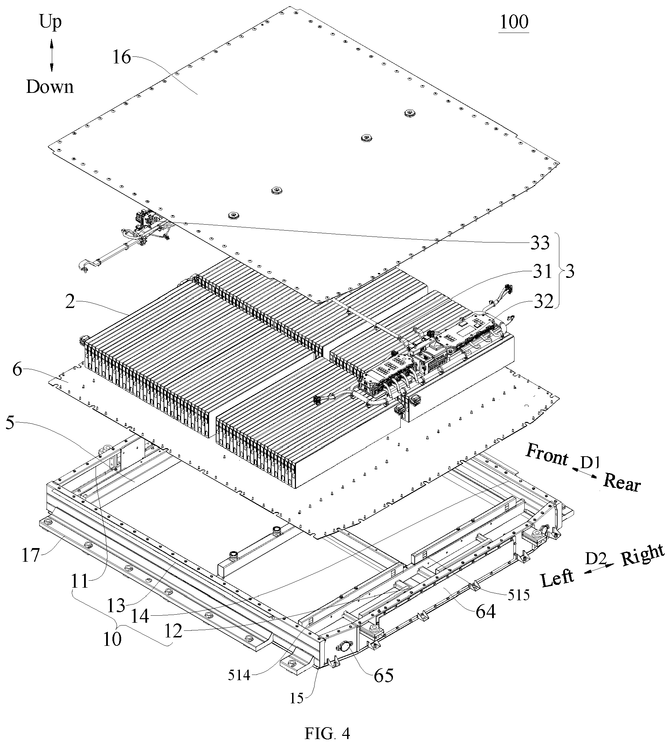

In FIG. 3 and FIG. 4, the battery group 2 includes four battery sub-groups 20 each located in one of the receiving sub-cavities V10.

In some specific embodiments, as shown in FIG. 14 and FIG. 6, each partition cross beam 51 includes a lower cross beam 511 and an upper cross beam 512. The lower cross beam 511 extends in the left-right direction. Two ends of the lower cross beam 511 are connected to the left side wall 13 and the right side wall 14 of the casing 1, respectively. The upper cross beam 512 extends in the left-right direction, and is fixedly connected above the lower cross beam 511. Each lower cross beam 511 is connected to at least two upper cross beams 512, which are spaced apart from each other.

For the same partition cross beam 51, a first notch 5131 is defined between a left upper cross beam 512 and the left side wall 13 of the casing 1, a second notch 5132 is defined between a right upper cross beam 512 and the right side wall 14 of the casing 1, and a third notch 5133 is defined between two adjacent upper cross beams 512. One third notch 5133 is provided above a connection between two adjacent partition longitudinal beams 52.

This solution of overlapping the horizontal and longitudinal beams can not only facilitate mounting, but can also support the third wiring harness 313 when the third wiring harness 313 passes through the battery group 2. This solution not only improves orderliness of wiring, but also avoids the need to insert the third wiring harness 313 into the receiving sub-cavity V10, reducing a probability of a pressure relief member 202 spraying an internal electrolyte towards the third wiring harness 313, thus reducing a risk of a short circuit or open circuit of the third wiring harness 313 due to this reduced probability.

In an embodiment of the present disclosure, the third wiring harness 313 is bound to the partition longitudinal beam 52 through the wiring harness snap, which reduces shaking of the third wiring harness 313 during vibration and the probability of loosening caused by shaking.

In some specific embodiments, as shown in FIG. 6 and FIG. 8, the first wiring harness 311 is located in the rear sub-cavity V12 and arranged around the first electrical portion 32. The first wiring harness 311 is electrically connected to the battery group 2, and is detachably and electrically connected to the first electrical portion 32. The second wiring harness 312 is located in the front sub-cavity V11 and arranged in the left-right direction at a rear side of the second electrical portion 33. The second wiring harness 312 is detachably and electrically connected to the second electrical portion 33. In this way, the first wiring harness 311 and the second wiring harness 312 are each constrained, reducing shaking and a risk of connection loosening caused by shaking.

Further, as shown in FIG. 6, the battery pack 100 further includes at least one fastening sleeve 53 configured to be connected to an external seat. The fastening sleeve 53 is disposed at the partition assembly 5. For example, the fastening sleeve 53 is fixedly connected to at least one partition cross beam 51. At least two fastening sleeves 53 are arranged at intervals at the at least one partition cross beam 51 in the left-right direction. In this way, when the battery pack 100 is applied in the vehicle 1000, a seat in a passenger space 220 may be engaged with the fastening sleeve 53 through the fastener. Therefore, there is no need to additionally arrange a seat mounting cross beam in the passenger space 220, improving structural compactness and reducing the number of parts.

In an embodiment of the present disclosure, the partition cross beam 51 is provided with fastening sleeves 53 in one-to-one correspondence with the seat fixing fasteners 66. A lower end of the seat fixing fastener 66 is threadedly connected in the fastening sleeve 53.

In an embodiment of the present disclosure, as shown in FIG. 6 and FIG. 1, a height of the partition cross beam 51 is smaller than a height of the casing 1. The fastening sleeves 53 are connected to a top of the partition cross beam 51 through welding. The top cover 16 of the casing 1 is provided with a seat fixing fastener 66 facing each fastening sleeve 53. In this way, the seat can be connected to each of the seat fixing fastener 66 and the fastening sleeve 53 through fasteners, realizing extension of a matching length in a vertical direction. Moreover, when the seat is stressed, an acting force is transmitted to the entire battery pack 100, and an impact force is dispersed by the entire battery pack 100.

In some specific embodiments, as shown in FIG. 2, a battery cell 201 in the battery sub-groups 20 is arranged in the left-right direction, and is provided with a pressure relief member 202 at a left end and/or right end of the battery cell 201. In an example of FIG. 2, each battery cell 201 in each battery sub-group 20 is provided with the pressure relief member 202 to improve its safety. The number of pressure relief members 202 on each battery cell 201 may be one or more, which is not limited here.

In an embodiment of the present disclosure, the battery cell 201 is in a sheet-like shape and extends in the second direction D2. A plurality of battery cells 201 are stacked in the first direction D1 to form one battery sub-group 20. Therefore, it is beneficial to an improvement in an arrangement density of the battery sub-groups 20 and an energy density of the battery pack 100.

A flow passage V101 is formed between each of the left and right ends of the battery sub-group 20 and an inner wall of the receiving sub-cavity V10. In this way, there is no need to provide another passage. The passage between the end of the battery sub-group 20 and the inner wall of the receiving sub-cavity V10 is used to discharge high-pressure gas discharged by the pressure relief member 202, which improves the utilization rate of the internal space. The flow passage V101 may also serve as a buffer channel for the battery sub-group 20.

In an embodiment of the present disclosure, a width x1 of the flow passage V101 ranges from 20 mm to 50 mm. Thus, flowability of the flow passage V101 is effectively ensured. Moreover, the width x1 of the flow passage V101 does not occupy excessive volume due to being overly wide. In an embodiment of the present disclosure, the width x1 of the flow passage V101 is 35 mm. The width x1 of the flow passage V101 refers to a dimension of the flow passage V101 in the second direction D2.

Correspondingly, an air pressure balance valve 65 may be provided on at least one of the front side wall 11 and the rear side wall 12, allowing an air flow between the at least one of the front side wall 11 and the rear side wall 12 and the flow passage V101 to be discharged from the air pressure balance valve 65.

In an embodiment of the present disclosure, as shown in FIG. 5, the rear side wall 12 of the casing 1 is provided with an external interface 102 extending through the rear side wall 12 of the casing 1, so that the discharged high-pressure gas can be discharged from a certain external interface 102. Further, in an embodiment of the present disclosure, as shown in FIG. 5, the air pressure balance valve 65 is provided at least one external interface 102. In this way, the air pressure balance valve 65 is switched on to discharge air when a high-pressure air flow is discharged inside the casing 1, and remains closed when air pressure is normal.

In some embodiments, as shown in FIG. 6, a front side wall 11 of the frame 10 is located adjacent to the bottom access opening 61. The battery pack 100 further includes a high-voltage electrical terminal 315 and a low-voltage electrical terminal 316 that are mounted at the front side wall 11 of the casing 1 and spaced apart from the second electrical portion 33 in the left-right direction. The rear side wall 12 of the casing 1 is provided with the external interface 102. This arrangement allows a position of the battery pack 100 for external power connection and communication does not interfere with the side access opening 101 located at front and rear sides of the battery pack 100. When the battery pack 100 is mounted on the vehicle 1000, since the electrical connection and communication part has a low failure rate, the part is placed at the front side and protected inside the vehicle body 200, which can further reduce its failure rate.

The second electrical portion 33 is adjacent to and arranged along the front side wall 11. The high-voltage electrical terminal 315 of the electrical module 3 may output the high-voltage electricity to the outside of the battery pack 100 to provide electrical energy. The low-voltage electrical terminal 316 of the electrical module 3 may output the low-voltage electricity to the outside of the battery pack 100 to transmit signals. The electrical connection structure 31 is connected to the second electrical portion 33, the low-voltage electrical terminal 316, and the high-voltage electrical terminal 315, and its mounting position is close to the front side wall 11, which can reduce the arrangement of the electrical connection structure 31 and the application costs of the electrical connections.

In some embodiments, as shown in FIG. 3, a bottom plate of the casing 1 is a detachable bottom protection plate 15, enabling the second electrical portion 33 to be disassembled and assembled when the bottom protection plate 15 is removed. The second electrical portion 33 may be mounted in or removed from the casing 1, and the bottom plate of the casing 1 is a detachable bottom protection plate 15, enabling the second electrical portion 33 to be disassembled and assembled when the bottom protection plate 15 is removed. When the second electrical portion 33 needs to be maintained, the bottom protection plate 15 is disengaged from the battery pack 100, and then the second electrical portion 33 is taken out.

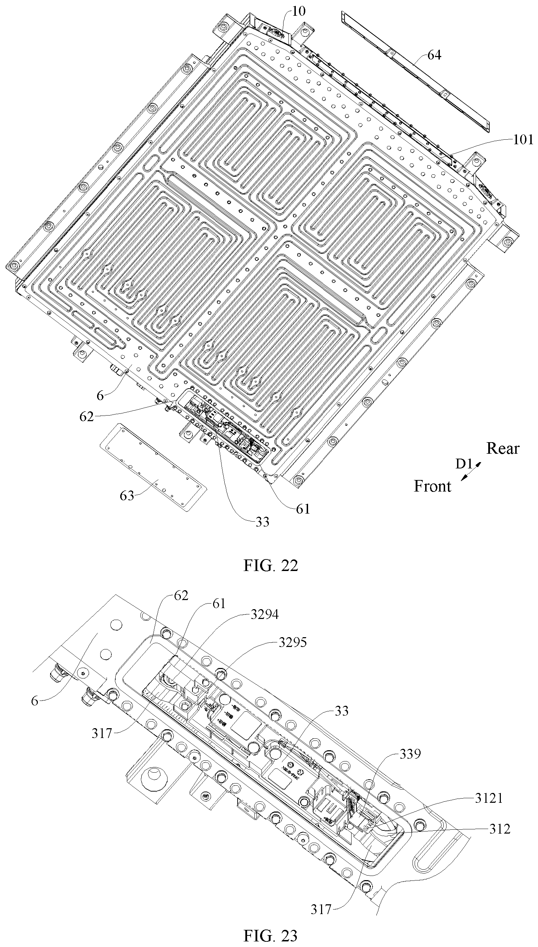

In an embodiment of the present disclosure, as shown in FIG. 22 and FIG. 23, the battery pack 100 further includes a liquid cooling plate 6 located below the battery group 2 and the electrical module 3. The bottom protection plate 15 is detachably connected below the liquid cooling plate 6. The liquid cooling plate 6 has a bottom access opening 61 corresponding to the second electrical portion 33. The bottom protection plate 15 covers the bottom access opening 61 and is used to open and close the bottom access opening 61.

The liquid cooling plate 6 has the bottom access opening 61. The bottom access opening 61 is located at a bottom of the battery pack 100, and its position corresponds to the second electrical portion 33. The bottom protection plate 15 may cover the bottom access opening 61. The liquid cooling plate 6 may be used to cool the battery group 2, keeping the battery group 2 within a safe temperature range.

The formation of the bottom access opening 61 at the liquid cooling plate 6 does not affect the disassembly of the second electrical portion 33. Moreover, all four peripheral edges of the liquid cooling plate 6 may each be connected to the bottom of the frame 10, further improving overall structural strength.

When the bottom protection plate 15 is applied in the vehicle 1000, on the one hand, the bottom protection plate 15 serves as the bottom plate of the vehicle 1000, and is capable of bearing a weight inside the vehicle 1000. On the other hand, the bottom protection plate 15 may protect the internal structure of the battery pack 100 and reduce damage.

In an embodiment of the present disclosure, as shown in FIG. 6, the liquid cooling plate 6 has a liquid flow channel formed in the liquid cooling plate 6, the liquid flow channel is configured to circulate cooling liquid. The liquid cooling plate 6 is provided with a liquid cooling pipe 601 for an inflow or outflow of the liquid. An end of the liquid cooling pipe 601 is provided with a liquid cooling connector 602 configured to be connected to an external water tank. The liquid cooling connector 602 may be mounted at the frame 10, for example, at the front side wall 11.

In some embodiments, the battery pack 100 includes two liquid cooling connectors 602 connected to a liquid inlet 6-02 and a liquid outlet 6-03 through the liquid cooling pipe 601. The two liquid cooling connectors 602 are mounted at the front side wall 11.

Further, as shown in FIG. 22, a sealing ring 62 needs to be provided around the periphery of the bottom access opening 61, to improve sealing performance of the bottom access opening 61 during use.

A position of the bottom access opening 61 is relatively flexible. For example, in FIG. 22, the liquid cooling plate 6 is provided with a sealing ring 62 arranged around the bottom access opening 61. For another example, in FIG. 37, the bottom protection plate 15 is provided with a sealing ring 62 arranged around the bottom access opening 61.

In other embodiments, as shown in FIG. 22, the battery pack 100 further includes a bottom access cover 63 covering the bottom access opening 61. The bottom access cover 63 is detachably connected to the liquid cooling plate 6 and located above the bottom protection plate 15. The bottom access cover 63 can protect the internal structure of the battery pack 100, preventing the dust, moisture, and the like from entering the battery pack 100 through the bottom access opening 61.

In an embodiment of the present disclosure, the bottom access cover 63 is provided with the sealing ring 62 arranged around the bottom access opening 61, further improving sealing protection for the bottom access opening 61.

Further, as shown in FIG. 37, the battery pack 100 includes a plurality of fastening bolts 611 configured to connect the bottom protection plate 15 and the liquid cooling plate 6 and distributed around the bottom access opening 61. Through the fastening bolts 611, the bottom protection plate 15 and the liquid cooling plate 6 at the bottom access opening 61 can be fastened, improving connection reliability and sealing performance at the bottom access opening 61.

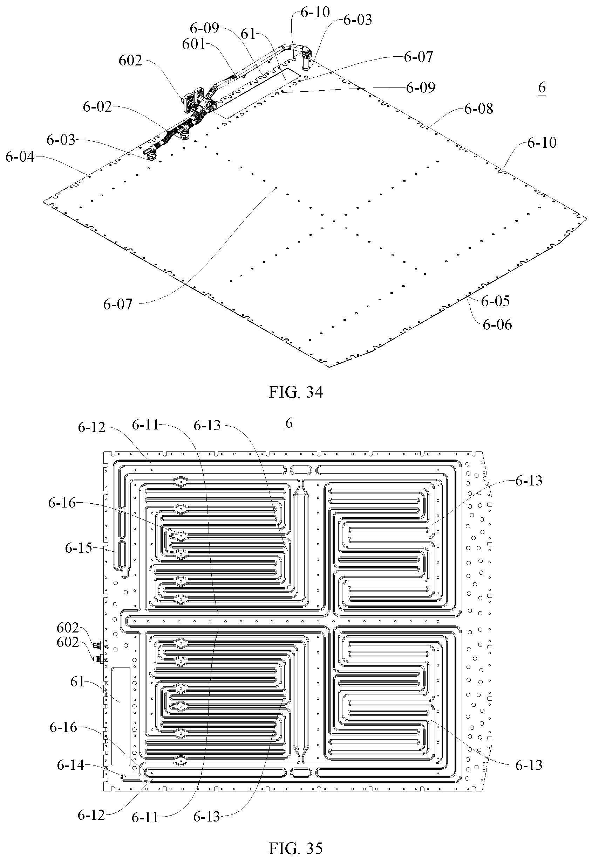

In some specific embodiments, as shown in FIG. 34 and FIG. 35, the battery pack is provided with the liquid cooling plate 6. The liquid cooling plate 6 has the bottom access opening 61 extending through the liquid cooling plate 6 in a thickness direction of the liquid cooling plate 6, and has the liquid flow channel 6-01 formed in the liquid cooling plate 6. The liquid inlet 6-02 and the liquid outlet 6-03 are formed at an upper surface of the liquid cooling plate 6. The bottom access opening 61 is located between the liquid inlet 6-02 and the liquid outlet 6-03.

By forming the bottom access opening 61 at the liquid cooling plate 6, at least part of the electrical module 3 of the battery pack 100 may be mounted above the bottom access opening 61, which allows a maintenance operation to be performed by opening the bottom access opening 61 when needed, improving convenience of the maintenance operation for the battery pack 100. By arranging the liquid inlet 6-02 and the liquid outlet 6-03 adjacent to the bottom access opening 61, the liquid cooling pipe 601 need to be connected above the liquid inlet 6-02 and the liquid outlet 6-03, and the at least part of the electrical module 3 needs to be mounted above the bottom access opening 61, which allows for a compact layout in this space without occupying other areas. A vacant area above the liquid cooling plate 6 may be used to arrange the battery sub-groups 20, improving a space utilization rate of the area above the liquid cooling plate 6. Moreover, the liquid inlet 6-02 and the liquid outlet 6-03 are located at two ends of the bottom access opening 61, and the liquid cooling pipe 601 connected to the liquid inlet 6-02 and the liquid outlet 6-03 is arranged adjacent to the electrical module 3. The use of the liquid cooling pipe 601 can improve the heat dissipation effect on the electrical module 3.

In an embodiment of the present disclosure, a side of the liquid cooling plate 6 is a connector side 6-04. The connector side 6-04 here is named based on a position where the liquid cooling connector 602 is connected to the battery pack 100. A side of the liquid cooling plate 6 adjacent to the liquid cooling connector 602 is the connector side 6-04. The bottom access opening 61 extends along the connector side 6-04. Each of the liquid inlet 6-02 and the liquid outlet 6-03 is arranged adjacent to the connector side 6-04. That is, the electrical module 3 (such as the second electrical portion 33) located above the bottom access opening 61 is arranged adjacent to the liquid cooling connector 602. In this way, a side of the casing 1 where the liquid cooling connector 602 is mounted does not need to be disassembled and assembled, and the electrical module 3 (such as the second electrical portion 33) here only needs to be disassembled, assembled, and maintained from the bottom, without mutual conflict, thereby avoiding an impact on reliability of liquid and current during conflicts.

In an embodiment of the present disclosure, the liquid inlet 6-02 is located at a middle part of the liquid cooling plate 6. Two liquid outlets 6-03 are provided and located at two opposite sides of the liquid inlet 6-02. The liquid inlet 6-02 and one liquid outlet 6-03 are located at two ends of the bottom access opening 61 in its length direction. In this way, the cooling liquid enters from the middle and exits from both sides. Since heat accumulates in a middle part inside the battery pack 100, low-temperature liquid enters from the middle part, improving a cooling effect on the middle part of the battery pack 100, thus improving overall temperature uniformity.

In some embodiments, the partition assembly 5 includes partition cross beams 51 extending in the left-right direction. The receiving sub-cavity V10 includes a front sub-cavity V11 located at a side of one of the partition cross beams 51, and the bottom access opening 61 is located in the front sub-cavity V11.

The liquid cooling plate 6 has a plurality of first liquid cooling connection holes 6-07. At least part of the plurality of first liquid cooling connection holes 6-07 directly faces the partition cross beams 51. The liquid cooling plate 6 is fixedly connected to the partition cross beams 51 through the at least part of the plurality of first liquid cooling connection holes 6-07.

In an embodiment of the present disclosure, the liquid cooling plate 6 has the plurality of first liquid cooling avoidance holes 6-09 arranged around the bottom access opening 61.

The at least part of the first liquid cooling avoidance holes 6-09 directly faces one of the partition cross beams 51 at a side of the front sub-cavity V11. The bottom protection plate 15 is detachably connected to the partition cross beam 51 through the at least part of the first liquid cooling avoidance holes 6-09.

In some optional embodiments, as shown in FIG. 34, the liquid cooling plate 6 has at least two rows of first liquid cooling connection holes 6-07. Two rows of first liquid cooling connection holes 6-07 among the at least two rows of first liquid cooling connection holes 6-07 are located at two sides of the bottom access opening 61. Each row of first liquid cooling connection holes 6-07 are arranged at intervals along a long side of the bottom access opening 61. The first liquid cooling connection holes 6-07 are used to fixedly connect the liquid cooling plate 6 to the partition assembly 5 of the battery pack 100. In this way, reliability of connection and fixation between the liquid cooling plate 6 and the upper frame 10 is improved, especially increasing reliability and stability at two sides of this part of the electrical module 3.

Certainly, the liquid cooling plate 6 in the present disclosure further has at least one row of second liquid cooling connection holes 6-08, which are also used to fixedly connect the liquid cooling plate 6 to the frame 10 of the battery pack 100.

Further, the liquid cooling plate 6 has at least two rows of first liquid cooling avoidance holes 6-09. Two rows of first liquid cooling avoidance holes 6-09 are located at the two sides of the bottom access opening 61. Each row of first liquid cooling avoidance holes 6-09 are arranged at intervals along the long side of the bottom access opening 61. A diameter of each of the first liquid cooling avoidance holes 6-09 is greater than a diameter of each of the first liquid cooling connection holes 6-07. The first liquid cooling avoidance hole 6-09 is used to avoid a fastener connecting the bottom protection plate 15 of the battery pack 100 to the frame 10. In this way, the connection between the bottom protection plate 15 or the bottom access cover 63 below and the frame 10 is facilitated. The two connections between the bottom protection plate 15 and the frame 10 and between the bottom access cover 63 and the frame 10 do not conflict with each other, reducing a probability of incorrect disassembly during disassembly and assembly.

Further, the liquid cooling plate 6 has a plurality of first liquid cooling connection holes 6-07 configured to fixedly connect the liquid cooling plate 6 to the partition assembly 5 and a plurality of second liquid cooling connection holes 6-08 configured to fixedly connect the liquid cooling plate 6 to the frame 10. A part of the plurality of first liquid cooling connection holes 6-07 directly faces the at least two partition cross beams 51, and another part of the plurality of first liquid cooling connection holes 6-07 directly faces the partition longitudinal beam 52. The plurality of second liquid cooling connection holes 6-08 are arranged along an edge of the liquid cooling plate 6.

Further, the liquid cooling plate 6 has a plurality of first liquid cooling avoidance holes 6-09 arranged around the bottom access opening 61 and a plurality of second liquid cooling avoidance holes 6-10 arranged along the edge of the liquid cooling plate 6. The bottom protection plate 15 is detachably connected above the liquid cooling plate 6 through the plurality of first liquid cooling avoidance holes 6-09 and the plurality of second liquid cooling avoidance holes 6-10.

In some embodiments, the liquid cooling plate 6 is located at the bottom of the frame 10. The liquid cooling plate 6 has a bottom access opening 61 directly facing one of the plurality of receiving sub-cavities V10. The liquid cooling plate 6 is fixedly connected to the frame 10 and at least part of the partition assembly 5 adjacent to the bottom access opening 61.

In some embodiments, as shown in FIG. 35, the liquid flow channel 6-01 includes a branching sub-channel 6-11 located at the middle part of the liquid cooling plate 6. The liquid inlet 6-02 is connected to an end of the branching sub-channel 6-11 adjacent to the connector side 6-04. The liquid flow channel 6-01 further includes two return sub-channels 6-12 located at two opposite sides of the branching sub-channel 6-11. The two return sub-channels 6-12 extend along two opposite sides of the liquid cooling plate 6. Two liquid outlets 6-03 are connected to ends of the two return sub-channels 6-12 adjacent to the connector side 6-04. The liquid flow channel 6-01 further includes a plurality of heat dissipation sub-channels 6-13 divided into two groups corresponding to the two return sub-channels 6-12. Each group of heat dissipation sub-channels 6-13 is connected between the branching sub-channel 6-11 and a return sub-channel 6-12 corresponding to the group of heat dissipation sub-channels 6-13. The plurality of heat dissipation sub-channels 6-13 are arranged in one-to-one correspondence with the plurality of battery sub-groups 20 in the battery pack 100.

In some embodiments, as shown in FIG. 33 to FIG. 35, two branching sub-channels 6-11 are provided and located at two sides of the partition longitudinal beam 52. An end of each of the two branching sub-channels 6-11 is located in the front sub-cavity V11 and connected to the liquid inlet 6-02.

In some embodiments, as shown in FIG. 13, FIG. 33, and FIG. 35, a plurality of heat dissipation sub-channels 6-13 are provided and located at the two sides of the partition longitudinal beam 52. Each of the plurality of heat dissipation sub-channels 6-13 is connected to a branching sub-channel 6-11 of the two branching sub-channels 6-11 adjacent to the heat dissipation sub-channel and corresponds to one of the plurality of receiving sub-cavities V10.

In some embodiments, as shown in FIG. 33 to FIG. 35, two return sub-channels 6-12 are provided and located at the two sides of the partition longitudinal beam 52. An end of each of the two return sub-channels 6-12 located in the front sub-cavity V11 is connected to one of the liquid outlets 6-03.

Literally, each of the branching sub-channels 6-11 is used for branching of the cooling liquid. The cooling liquid introduced through the liquid inlet 6-02 is dispersed to each heat dissipation sub-channel 6-13 through the branching sub-channel 6-11. The cooling liquid in each heat dissipation sub-channel 6-13 flows back to the liquid outlets 6-03 through the return sub-channels 6-12.

In order to improve the cooling effect, the heat dissipation sub-channel 6-13 may be in an S shape or other shapes, and has a plurality of bent segments to arrange a longer heat dissipation sub-channel 6-13 in a smaller area.

Further, the liquid flow channel 6-01 further includes a first extending sub-channel 6-14 and a second extending sub-channel 6-15. The first extending sub-channel 6-14 is located at a side of the bottom access opening 61 away from the liquid inlet 6-02 and connected to a return sub-channel 6-12 adjacent to the first extending sub-channel 6-14. One of the liquid outlets 6-03 is arranged facing the first extending sub-channel 6-14. The second extending sub-channel 6-15 is connected to the other return sub-channel 6-12, and is bent with respect to the return sub-channel 6-12 and extends towards the liquid inlet 6-02. The other liquid outlet 6-03 is arranged facing an end of the second extending sub-channel 6-15 adjacent to the liquid inlet 6-02. In this way, the first extending sub-channel 6-14 and the second extending sub-channel 6-15 are used to flexibly set the positions of the liquid outlets 6-03, facilitating the arrangement of the liquid cooling pipe 601. The liquid cooling pipe 601 can not only cool the second electrical module 33, but also be disposed at a short distance from the liquid cooling connector 602.

In some embodiments, as shown in FIG. 2 and FIG. 4 to FIG. 6, the frame 10 has a left side wall 13 and a right side wall 14. A battery group 2 of the battery pack 100 includes a plurality of battery sub-groups 20. The plurality of battery sub-groups 20 is distributed in the receiving sub-cavities V10 between two adjacent partition cross beams 51. A left battery sub-group 20 of the plurality of battery sub-groups 20 is spaced apart from the left side wall 13 to form a flow passage V101, and a right battery sub-group 20 of the plurality of battery sub-groups 20 is spaced apart from the right side wall 14 to form a further flow passage V101. The two return sub-channels 6-12 are located directly below the two flow passages V101.

In an embodiment of the present disclosure, as shown in FIG. 34 and FIG. 35, the liquid cooling plate 6 includes an upper liquid plate 6-05 and a lower liquid plate 6-06 that are arranged in a stacked manner. The liquid flow channel 6-01 is formed by downward deformation of the lower liquid plate 6-06. The upper liquid plate 6-05 is used to close the liquid flow channel 6-01. The liquid inlet 6-02 and the liquid outlets 6-03 are formed at the upper liquid plate 6-05. The lower liquid plate 6-06 has at least one welding through hole 6-061 having a welding point. In this way, it is convenient to set welding points along an edge of the welding through hole 6-061, making bonding between the upper liquid plate 6-05 and the lower liquid plate 6-06 firmer.

Further, in an embodiment of the present disclosure, the welding through hole 6-061 is arranged adjacent to the liquid flow channel 6-01. An avoidance arcuate edge 6-16 is formed at a side edge of the liquid flow channel 6-01 adjacent to the welding through hole 6-061, and the avoidance arcuate edge 6-16 is arranged around the welding through hole 6-061, to be connected to a structure above the bottom protection plate 15.

In an embodiment of the present disclosure, an upper surface of the bottom protection plate 15 is provided with an upwardly protruding thickened protruding rib 151. A projection surface of the thickened protruding rib 151 on the liquid cooling plate 6 completely covers the bottom access opening 61. In this way, after the bottom protection plate 15 is connected and fixed to the upper portion of the frame 10, the thickened protruding rib 151 is pressed upward, thereby compressing the bottom access opening 61 and improving the sealing performance.

A bottom main plate 150 is a structural main body of the bottom protection plate 15, and is used to be connected to the bottom of the battery pack 100 to play a protection and decorative role. By providing the thickened protruding rib 151 at an upper surface of the bottom main plate 150, the thickened protruding rib 151 protrudes upward with respect to the bottom main plate 150 and may be supported at an edge of the bottom access opening 61 of the battery pack 100. For example, when the battery pack 100 is provided with the liquid cooling plate 6 at its bottom, the liquid cooling plate 6 has the bottom access opening 61 facing an electrical portion (such as the second electrical portion 33 described above), and the thickened protruding rib 151 may just be supported at the edge of the bottom access opening 61 to play a supporting role. A sealing structure is usually provided at the edge of the bottom access opening 61, and the thickened protruding rib 151 compresses the sealing structure to improve a sealing effect. Therefore, the bottom protection plate 15 of the present disclosure can improve sealing reliability around the bottom access opening 61, thereby improving sealing protection for the electrical module of the battery pack 100.

In an embodiment of the present disclosure, the thickened protruding rib 151 is a single part, and the bottom main plate 150 is a single part. The thickened protruding rib 151 is connected to the bottom main plate 150 through welding or gluing. Thus, when the bottom protection plate 15 is disassembled and assembled, the thickened protruding rib 151 and the bottom main plate 150 can be integrally formed without displacement. Moreover, it is helpful to improve a sealing effect between the thickened protruding rib 151 and the bottom main plate 150.

When the bottom protection plate 15 includes the sealing ring 62, the sealing ring 62 may be placed at an upper surface of the thickened protruding rib 151, and extends along an inner edge of the thickened protruding rib 151. On the one hand, this arrangement facilitates positioning. On the other hand, in this arrangement, the sealing ring 62 is compressed upward during a fastening process using the bottom protection plate 15, thereby ensuring sealing performance of the edge of the bottom access opening 61.

Further, a plurality of first bottom connection holes 156 are provided and arranged at intervals around the sealing ring 62. In this way, when the fasteners are connected at the plurality of first bottom connection holes 156, a plurality of compression points are formed around the sealing ring 62 after fastening, further improving the sealing effect.

In some specific embodiments, a side of the thickened protruding rib 151 is arranged flush with a side of the bottom main plate 150. It can be understood that when the bottom protection plate 15 is connected to the frame 10 of the casing 1, a connection structure at the edge is sealed. By arranging a side of the thickened protruding rib 151 flush with a side of the bottom main plate 150, an upper part of a side of the thickened protruding rib 151 faces a side of the frame 10, and an electrical portion facing the side of the thickened protruding rib 151 is adjacent to the frame 10. On the one hand, the electrical portion can be supported and protected by a frame 10 with a relatively high structural strength. On the other hand, the structure is concentrated adjacent to the frame 10, improving an arrangement density of parts. Moreover, from an external viewing angle, after a side of the thickened protruding rib 151 is arranged flush with a side of the bottom main plate 150, the connected laminated structure becomes visible externally, thereby detecting whether a part is missing.

In some embodiments, as shown in FIG. 37, the bottom protection plate 15 further includes a bottom edge strip 153 stacked above the bottom main plate 150 and arranged along an edge of the bottom main plate 150. The bottom edge strip 153 has a second bottom connection hole 157 extending downward through the bottom main plate 150. It can be understood that when the battery pack 100 is subjected to impact, corners of the battery pack 100 are most severely affected by impact and deformation. Therefore, in the present disclosure, by providing the bottom edge strip 153, a protection and support effect on the edge of the bottom protection plate 15 can be improved, and a case where the edge of the bottom protection plate 15 is folded or curled due to its thinness during disassembly and assembly can be reduced. In addition, when the second bottom connection hole 157 is formed on the bottom edge strip 153, and the fastener is used to pass through the second bottom connection hole 157 to be connected to the frame 10, the bottom edge strip 153 can reduce a probability of the fastener penetrating the bottom protection plate 15, improving connection reliability of the fastener at the second bottom connection hole 157.

In an embodiment of the present disclosure, the thickened protruding rib 151 is located at a side of the bottom main plate 150, and the bottom edge strip 153 is a ring-shaped part matching an edge shape of the bottom main plate 150. The bottom edge strip 153 has an avoidance notch 1531 corresponding to the thickened protruding rib 151. In this way, it is beneficial to keep the bottom edge strip 153 flat, avoiding an overly complex shape, and reducing sealing difficulty.

In an embodiment of the present disclosure, a height h3 of the bottom edge strip 153 is greater than a height h4 of the thickened protruding rib 151. That is, an upper surface of the bottom edge strip 153 is higher than an upper surface of the thickened protruding rib 151. In this way, a gap is formed due to the height difference when the bottom protection plate 15 is connected to the bottom of the casing 1, which is convenient for setting a sealing structure. For example, when the bottom access cover 63 is provided above the thickened protruding rib 151, this gap may receive the bottom access cover 63. Alternatively, when the sealing ring 62 is provided, a thicker sealing ring 62 may be provided, providing a certain selection space for the sealing structure.

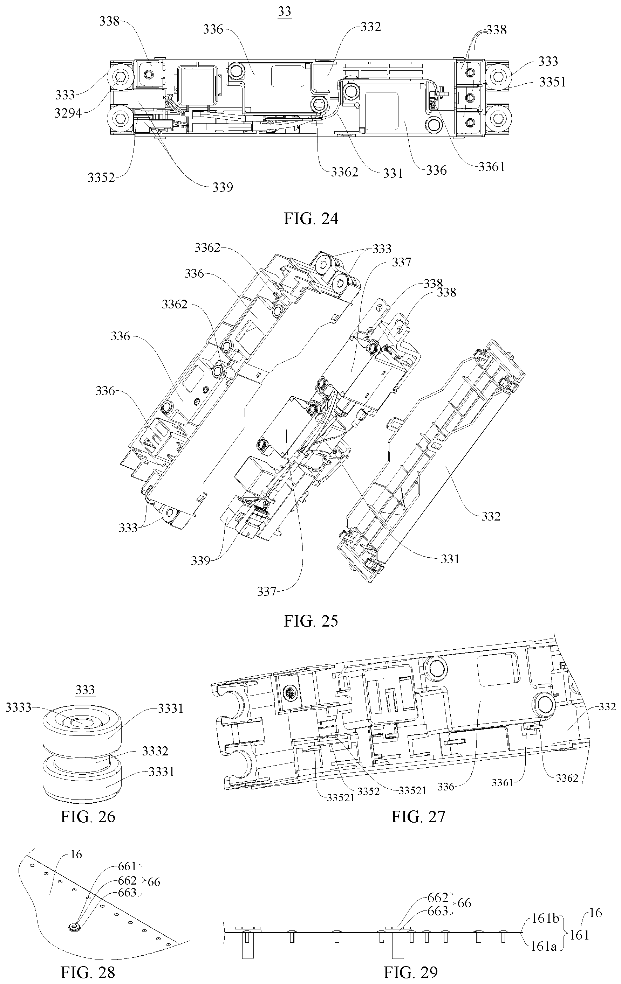

In some optional embodiments, as shown in FIG. 28, a shock-absorbing layer 18 may be formed at the upper surface of the bottom protection plate 15 to improve buffer protection for the internal battery group 2 and electrical module 3.

In some embodiments, as shown in FIG. 13 and FIG. 6, the casing 1 is internally provided with a fixing plate 67 located above the second electrical portion 33. The second electrical portion 33 is detachably connected to the fixing plate 67 through a fourth bolt 3294. A head of the fourth bolt 3294 is located at a lower end of the structure, i.e., a mounting direction of the fourth bolt 3294 is away from the fixing plate 67 and faces the bottom access opening 61. A projection of the fourth bolt 3294 on the liquid cooling plate 6 is located within a coverage of the bottom access opening 61. Thus, the fourth bolt 3294 can be disassembled or mounted through the bottom access opening 61, improving convenience of disassembly or mounting.

As shown in FIG. 23 and FIG. 24, in some embodiments, the second electrical portion 33 includes a second electrical housing 332 configured to receive electrical elements. In an embodiment of the present disclosure, the second electrical portion 33 further includes a first extension plate 3351 connected to at least one side of the second electrical housing 332. The first extension plate 3351 has an engagement groove extending through a side of the first extension plate 3351 away from the second electrical housing 332. The battery pack 100 further includes a shock-absorbing post 333 arranged vertically.

As shown in FIG. 26, the shock-absorbing post 333 includes two thick post segments 3331 and a thin post segment 3332 located between the two thick post segments 3331. As shown in FIG. 24 and FIG. 25, the thin post segment 3332 is engaged in the engagement groove, and the two thick post segments 3331 are clamped at upper and lower sides of the first extension plate 3351. The shock-absorbing post 333 has a central hole 3333, and the fourth bolt 3294 passes through the central hole 3333 and is connected to the fixing plate 67. By providing the shock-absorbing post 333, on the one hand, the shock-absorbing post 333 can be connected to the fixing plate 67 to improve connection reliability. On the other hand, the shock-absorbing post 333 can absorb vibration of the second electrical portion 33 to protect the electrical elements received in the second electrical housing 332.

For ease of disassembly, the electrical connection structure 31 is electrically connected to the second electrical portion 33 through a flexible wiring harness. For example, a communication connector of the second electrical portion 33 is a first signal transmission interface 339, and a second wiring harness 312 of the electrical connection structure 31 is connected to a second signal transmission interface 3121. The first signal transmission interface 339 and the second signal transmission interface 3121 are plugged and connected to each other.

As shown in FIG. 23, the first signal transmission interface 339 is located at a bottom of the second electrical housing 332. Therefore, when the bottom access opening 61 is opened, a state of the interface can be observed very conveniently. In an embodiment of the present disclosure, the second signal transmission interface 36 is plugged into the first signal transmission interface 339 from a side. In this way, while facilitating manual plugging and unplugging of the second signal transmission interface 36, a gravity of wires carried by the interface can be utilized to reduce shaking.

In an embodiment of the present disclosure, the first signal transmission interface 339 is connected to an interior of the second electrical housing 332 through a plurality of fourth flexible wires 331. Thus, the second electrical portion 33 can be connected to the electrical connection structure 32 through the first transmission interface 319.

In some specific embodiments, as shown in FIG. 25, the second electrical housing 332 of the second electrical portion 33 is detachably connected within the casing 1. The second electrical portion 33 includes a main relay 337, an electrical connection strip 338, and a first transmission interface 319. The main relay 337 is disposed within the electrical housing 1. An end of the electrical connection strip 338 is connected to the main relay 337, and another end of the electrical connection strip 338 is located outside the second electrical housing 332. The electrical connection strip 338 is configured to connect high-voltage electricity. The main relay 337 may control the high-voltage electricity.

In an embodiment of the present disclosure, the electrical connection structure 32 includes a copper busbar 317 and a second transmission interface 37. An end of the copper busbar 317 is connected to the other end of the electrical connection strip 338 through a fifth bolt 3295. The second signal transmission interface 36 is plugged into the first signal transmission interface 339, thereby establishing an electrical connection between the second electrical portion 33 and the electrical connection structure 32.

Exemplarily, the copper busbar 317 is an elongated shape and has a certain toughness to be bendable. An insulating cover is provided at a connection between the copper busbar 317 and the electrical connection strip 338, and is connected to the second electrical housing 332. When the second electrical portion 33 needs to be removed, the second electrical portion 33 shall first be de-energized. Next, the insulating cover is removed, and a fixing structure between the copper busbar 317 and the electrical connection strip 338 is disengaged. Then, the fifth bolt 3295 may be loosened. By unplugging the second transmission interface 37, the fourth bolt 3294 is exposed, and the fourth bolt 3294 may be loosened.

As shown in FIG. 27, in some embodiments, the second electrical portion 33 further includes a second extension plate 3352 connected to the second electrical housing 332. An engagement hook 33521 is provided at each of two opposite sides of the second extension plate 3352. Two first signal transmission interfaces 339 are provided and located at the two opposite sides of the second extension plate 1352. Each first signal transmission interface 339 has an engagement groove engaged with the engagement hook 33521. Thus, the first signal transmission interfaces 339 can be fixed on the second electrical housing 332, which can reduce connection costs and improve connection reliability through the snap-fit connection form.

As shown in FIG. 25, in some embodiments, two main relays 337 are provided and spaced apart from each other, and two lower protrusions 336 protruding downwardly are formed at the bottom of the second electrical housing 332, the two lower protrusions 336 cover lower parts of the two main relays 337, respectively. The bottom of the second electrical housing 332 has a second through-hole 3361 adjacent to each of the two lower protrusions 336. A part of the fourth flexible wire 331 passes through one of the second through-holes 3361 and extends into the second electrical housing 332, and another part of the fourth flexible wire 331 passes through the other second through-hole 3361 and extends into the second electrical housing 332. In this way, the second electrical housing 332 can be utilized to limit an arrangement position of the fourth flexible wire 331, thereby reducing a probability of interference with other components and an adverse effect on the signal.

In an embodiment of the present disclosure, as shown in FIG. 25 and FIG. 27, a wire clamp 3362 is provided at a side of at least one lower protrusion 336 and is configured to limit the fourth flexible wire 331. Thus, a movement of the wire clamp 3362 can be limited, reducing swing of the wire clamp 3362.

In some embodiments, as shown in FIG. 28 and FIG. 29, the top cover 16 includes a cover body 161 and seat fixing fasteners 66. The cover body 161 has at least two first assembly holes in the same row. The first assembly holes are located in a middle region of the cover body 161. The seat fixing fasteners 66 are disposed at the first assembly holes in a one-to-one correspondence. Lower ends of the seat fixing fasteners 66 are located in the frame 10 for fixation, and upper ends of the seat fixing fasteners 66 are used to be connected to the seat 300. That is, the seat fixing fasteners 66 are placed inside the frame 10 and may be directly or indirectly connected to the frame 10. The seat 300 may be connected to the seat fixing fasteners 66 through fasteners. When the seat 300 is stressed, the acting force is transmitted to the entire battery pack 100, and the impact force is dispersed by the entire battery pack 100.

With this design, after the battery pack 100 is mounted to the vehicle body 200, the battery pack 100 may be integrated with the vehicle body 200. After an external impact borne by the vehicle body 200 is dispersed to various positions, a damage degree of the dispersed impact force is reduced. Moreover, the battery pack 100 may also serve as a part of a chassis of the vehicle body 200, so that a weight of the rest of chassis of the vehicle body 200 can be greatly reduced. Similarly, the top cover 16 may serve as a part of a floor of a passenger space 220, so that a weight of the rest of floor of the vehicle body 200 can be greatly reduced. Moreover, the number of parts and assembly processes can also be reduced.

In some specific embodiments, as shown in FIG. 28 and FIG. 29, the seat fixing fastener 66 has a seat fixing threaded hole 661 extending downward from an upper end of the seat fixing fastener 66. In this way, the seat 300 can be connected to the seat fixing fastener 66 through a threaded fastener. For example, a seat bottom beam is provided at a bottom of the seat 300, and has a through hole formed thereon. The bolt passes through the through hole from top to bottom and then is engaged to the seat fixing threaded hole 661. This design can also achieve detachable assembly, while allowing for a firm and reliable connection between the battery pack 100 and the seat 300.

In an embodiment of the present disclosure, the seat fixing threaded hole 661 extends through the seat fixing fastener 66 in the up-down direction, thereby reducing processing difficulty. Certainly, it is not excluded that in some solutions, the seat fixing threaded hole 661 is not a through hole, and it is a blind hole.

Further, as shown in FIG. 28, an upper end of the seat fixing fastener 66 is provided with a rotation platform 662 that surrounds the seat fixing threaded hole 661. The rotation platform 662 is annular.

In an embodiment of the present disclosure, an inner contour of the rotation platform 662 is polygonal. In this way, a tool (such as a screwdriver or an electric wrench) can be conveniently used to be engaged with an interior of the rotation platform 662 to drive the seat fixing fastener 66 to rotate for assembly, improving assembly efficiency of the rotation platform 662.

In an embodiment of the present disclosure, an outer contour of the rotation platform 662 is polygonal. In this way, a tool (such as a wrench or an electric wrench) can be conveniently used to be engaged with the rotation platform 662 to drive the seat fixing fastener 66 to rotate for assembly, improving the assembly efficiency of the rotation platform 662. In some solutions, after the seat 300 is mounted on the battery pack 100, the tool may be engaged with the rotation platform 662 from the bottom of the seat 300, allowing the seat fixing fastener 66 to be tightened or loosened.

In an embodiment of the present disclosure, the seat fixing fastener 66 further includes a support circular platform 663 located below the rotation platform 662. The support circular platform 663 serves as an integrally formed washer on the seat fixing fastener 66, which increases a contact area between a head of the seat fixing fastener 66 and the top cover 16. Moreover, a pressure applied by the seat fixing fastener 66 to the top cover 16 during rotation is balanced in a circumferential direction, reducing tearing of the top cover 16 due to concentrated stress generated around the first assembly hole. Further, the outer contour of the rotation platform 662 is hexagonal, and a diameter of its circumscribed circle is smaller than a diameter of the support circular platform 663. In this way, when a tool is engaged with the outer contour of the rotation platform 662, the support circular platform 663 can separate the tool from the top cover 16, reducing wear of the top cover 16 caused by the tool.

Further, in an embodiment of the present disclosure, an outer peripheral surface of the seat fixing fastener 66 is provided with external threads. The seat fixing fastener 66 is connected to the interior of the frame 10 through the external threads, thus improving the assembly efficiency.

In some embodiments, as shown in FIG. 29, the cover body 161 is composed of at least two layers including a hard layer 161a and an insulating buffer layer 161b. The hard layer 161a is used to ensure overall rigidity of the top cover 16, while the buffer layer 161b may realize buffering protection. Moreover, the use of the buffer layer 161b makes the sealing connection very convenient, and the buffer layer 161b, made of an insulating material, can improve both internal and external protection for the battery pack 100. In an embodiment of the present disclosure, the hard layer 161a may be a steel plate layer or other metal layers. In another embodiment of the present disclosure, the buffer layer 161b may be a plastic layer, a composite plastic layer, a rubber layer, or the like, which is not limited herein.

In some embodiments, as shown in FIG. 30 to FIG. 33, the frame 10 is formed by sequentially connecting a plurality of frame side beams 10-1 in a length direction of the frame 10 to finally form an annular structure referred to as the frame 10. In an embodiment of the present disclosure, the front side wall 11 is composed of at least one frame side beam 10-1, the rear side wall 12 is composed of at least one frame side beam 10-1, the left side wall 13 is composed of at least one frame side beam 10-1, and the right side wall 14 is composed of at least one frame side beam 10-1. Each frame side beam 10-1 includes at least two frame body portions 10-10 distributed in the height direction, and a closed frame body cavity 10-40 is formed in each frame body portion 10-10. Each frame side beam 10-1 may include two frame body portions 10-10 sequentially stacked in the height direction. In some solutions, as shown in FIG. 30, two adjacent frame body portions 10-10 are connected by a connection rib 10-6. In an embodiment of the present disclosure, the two frame body portions 10-10 and the connection rib 10-6 are integrally roll-formed from a steel plate or are an integrally formed extruded aluminum profile.

Each frame side beam 10-1 is integrally roll-formed from a steel plate or is an integrally formed extruded aluminum profile. In this way, all frame body portions 10-10 of each frame side beam 10-1, or all the frame body portions 10-10 and all connection ribs 10-6, are continuous. Moreover, each side of the frame body portion 10-10 is formed by rolling or extruding, rather than being formed by stretching ordinary profiles. In this way, on the one hand, welding between the sides of the same frame body portion 10-10 and between the two adjacent frame body portions can be reduced, thereby reducing processing procedures. On the other hand, the two adjacent frame body portions not only have a spliced and stacked positional relationship, but also are tied together along their connecting edges, resulting in stronger integrity and a significant improvement in overall structural strength.

In an embodiment of the present disclosure, the connection rib 10-6 is connected between two frame body portions 10-10. In some specific embodiments, the high-voltage electrical terminal 315 and the low-voltage electrical terminal 316 are mounted at a connection rib 10-6 of the front side wall 11, and the side access opening 101 is formed at a connection rib 10-6 of the rear side wall 12. Further, as shown in FIG. 31, the mounting beam 17 is integrally roll-formed from a steel plate or is an integrally formed extruded aluminum profile. In an embodiment of the present disclosure, the mounting beam 17 includes at least one mounting portion 17-10. The mounting portion 17-10 includes a mounting cavity 17-40 extending through the mounting portion 17-10 in a length direction of the mounting portion 17-10 to absorb most of external force energy, which reduces structural vibration, improves structural safety, and also reduces noise.

In some embodiments, as shown in FIG. 3 and FIG. 14, in an embodiment of the present disclosure, the partition assembly 5 includes at least one partition beam 50. The partition beam 50 further includes at least two partition portions 50-10 arranged in the height direction. A partition cavity 50-40 is formed in each of the partition portions 50-10, and extends in a length direction of the partition beam 50.

In an embodiment of the present disclosure, each partition portion 50-10 is integrally roll-formed from a steel plate or is an integrally formed extruded aluminum profile. Each side of the partition portion 50-10 is formed by rolling or extruding, rather than being formed by stretching ordinary profiles. In this way, on the one hand, the welding between the sides of the same partition portion 50-10 and between the two adjacent frame body portions can be reduced, thereby reducing the processing procedures. On the other hand, the two adjacent frame body portions not only have the spliced and stacked positional relationship, but also are tied together along their connecting edges, resulting in stronger integrity and a significant improvement in the overall structural strength.

In some embodiments, the plurality of partition beams 50 of the partition assembly 5 include at least two partition cross beams 51. Two adjacent partition cross beams 51 are spaced apart from each other in the front-rear direction. The battery group 2 of the battery pack 100 is located between the foremost partition cross beam 51 and the rearmost partition cross beam 51. The receiving sub-cavity V10 includes at least one of the front sub-cavity V11 and the rear sub-cavity V12.

When the receiving sub-cavity V10 includes the front sub-cavity V11, the receiving sub-cavity V10 is used for mounting the electrical module 3 of the battery pack 100, and the front sub-cavity V11 is defined between the foremost partition cross beam 51 and the front side wall 11. When the receiving sub-cavity V10 includes the rear sub-cavity V12, the receiving sub-cavity V10 is used for mounting the electrical module 3 of the battery pack 100, and the rear sub-cavity V12 is defined between the rearmost partition cross beam 51 and the rear side wall 12. That is, an electronic control part may be integrally formed and disposed in the front sub-cavity V11 or the rear sub-cavity V12. The electronic control part may also be divided into two parts that are disposed in the front sub-cavity V11 or the rear sub-cavity V12, respectively.

In some embodiments, the bottom access opening 61, a liquid inlet 6-02 and a liquid outlet 6-03 of the liquid cooling plate 6 are each located in the front sub-cavity V11.

In some embodiments, the partition portion 50-10 is a rectangular tube, which is convenient for stacking and can reduce interference with the battery group 2.

In an embodiment of the present disclosure, two partition portions 50-10 are stacked in the height direction on the partition cross beam 51. The two partition portions 50-10 are connected through welding, or fixedly connected by bolts. Alternatively, the two partition portions 50-10 are integrally roll-formed from a steel plate or are an integrally formed extruded aluminum profile.

In some embodiments, the partition assembly 5 further includes a partition longitudinal beam 52. The partition longitudinal beam 52 is connected between every two adjacent partition cross beams 51 of the at least two partition cross beams 51, to divide a space between the two adjacent partition cross beams 51 into two receiving sub-cavities V10 of the plurality of receiving sub-cavities V10.

In some embodiments, at least one partition cross beam 51 includes a lower cross beam 511 extending in the left-right direction and an upper cross beam 512 extending in the left-right direction. Two ends of the lower cross beam 511 are connected to the left side wall 13 and the right side wall 14, respectively. The upper cross beam 512 is fixedly connected above the lower cross beam 511. At least two upper cross beams 512 are spaced apart from each other and connected to the lower cross beam 511.

For the same partition cross beam 51, a first notch 5131 is defined between a left side of the upper cross beam 512 and the left side wall 13, a second notch 5132 is defined between a right side of the upper cross beam 512 and the right side wall 14, and a third notch 5133 is defined between two adjacent upper cross beams 512. The third notch 5133 is provided at a connection between the partition longitudinal beam 52 and the partition cross beam 51.

In some embodiments, as shown in FIG. 30, the upper cross beam 512 includes at least one partition portion 50-10 arranged in the height direction. The upper cross beam 512 is roll-formed from the same steel plate or is an integrally formed extruded aluminum profile. As shown in FIG. 30, the lower cross beam 511 includes at least one partition portion 50-10 arranged in the height direction. The lower cross beam 511 is roll-formed from the same steel plate or is an integrally formed extruded aluminum profile.

In some embodiments, an end of the partition longitudinal beam 52 is fixed to the lower cross beam 511 through welding, which does not affect the setting of the notches, ensures a sufficiently long welding line, and improves welding reliability. An end of the partition cross beam 51 is welded to the frame side beam 10-1 through a connecting plate 54.

In an embodiment of the present disclosure, the battery sub-group 20 is spaced apart from the partition longitudinal beam 52. In this way, a flow passage is formed at a side of the battery sub-group 20 facing the partition longitudinal beam 52, facilitating flow of the air flow and discharge of a high-temperature air flow.

In some embodiments, each battery sub-group 20 is provided with a first busbar 203. A first busbar 203 on a left side of the battery group 2 extends into the front sub-cavity V11 or the rear sub-cavity V12 through its adjacent first notch 5131, and a first busbar 203 on a right side of the battery group 2 extends into the front sub-cavity V11 or the rear sub-cavity V12 through its adjacent second notch 5132. In this way, positions of the first busbars 203 are clear and neat. On the one hand, the first busbar 203 can be cooled by the airflow flowing through the front sub-cavity V11 or the rear sub-cavity V12. On the other hand, the first busbar 203 is not located in the middle part of the battery pack 100, reducing the interference with wiring harnesses. As shown in FIG. 7, the entire electrical connection structure 31 is made neat and orderly.

In an embodiment of the present disclosure, as shown in FIG. 2, the battery group 2 is further provided with two second busbars 204 adjacent to the first electrical portion 32. The two second busbars 204 are configured to be connected in series with the fuse 3212, to perform voltage reduction protection at a high voltage by using the fuse 3212. In an embodiment of the present disclosure, the second busbars 204 are located in the rear sub-cavity V12 and at a front side of the first BDU unit 321.

In an embodiment of the present disclosure, as shown in FIG. 3, at least one partition cross beam 51 has a first hanging hole 514 corresponding to the first busbar 203. In this way, the first busbar 203 and structures connected to the first busbar 203 can be suspended from the first hanging hole 514, improving structural reliability and stability of the connection. The rearmost partition cross beam 51 has a second hanging hole 515 corresponding to the second busbar 204.

In some embodiments, the electrical connection structure 31 includes a first wiring harness 311, a second wiring harness 312, and a third wiring harness 313. The first wiring harness 311 is located in the rear sub-cavity V12 and arranged around the first electrical portion 32. The first wiring harness 311 is electrically connected to a first busbar 203 of an adjacent battery group 2, and is detachably and electrically connected to the first electrical portion 32. The second wiring harness 312 is located in the front sub-cavity V11. The second wiring harness 312 is detachably and electrically connected to the second electrical portion 33, and is electrically connected to a first busbar 203 of an adjacent battery group 2. The third wiring harness 313 is connected between the first wiring harness 311 and the second wiring harness 312. The third wiring harness 313 is placed above the partition longitudinal beam 52 and passes through the partition cross beam 51.

A plurality of first snap-fit members 361 are snap-fitted on the rearmost partition cross beam 51, and sleeved on the first wiring harness 311. A plurality of second snap-fit members 362 are snap-fitted on the foremost partition cross beam 51, and sleeved on the second wiring harness 312. A plurality of third snap-fit members 363 are snap-fitted on the partition longitudinal beam 52, and sleeved on the third wiring harness 313.

In an embodiment of the present disclosure, the partition longitudinal beam 52 is lower than the partition cross beam 51. In this way, when the second wiring harness 312 passes from the partition longitudinal beam 52 through the partition cross beam 51, the second wiring harness 312 can be constrained to some extent by the partition cross beam 51, preventing the second wiring harness 312 from being too high and interfering with a second protection cover 15. In an embodiment of the present disclosure, the partition longitudinal beam 52 is arranged flush with the lower cross beam 511.

In some embodiments, the rear side wall 12 includes a middle segment 121 and a side segment 122 connected to each of two sides of the middle segment 121. The middle segment 121 protrudes backward with respect to the side segment 122. The side access opening 101 is located at the middle segment 121. The air pressure balance valve 65 is mounted at the side segment 122. A first mounting beam 171 is connected to the middle segment 121 outside the casing 1. Outside the casing 1, a second mounting beam 172 is connected to each of the left side wall 13 and the right side wall 14.

In some embodiments, as shown in FIG. 33, the battery pack 100 further includes an insulation and heat-insulation cover 81 configured to cover the partition assembly 5 and separate the partition assembly 5 from the battery group 2. In an embodiment of the present disclosure, a part of the insulation and heat-insulation cover 81 is attached to the left side wall 11 and the right side wall 12 to separate the left side wall 11 and the right side wall 12 from the battery group 2.

As shown in FIG. 38, the vehicle 1000 according to an embodiment of the present disclosure includes a vehicle body 200 and the battery pack 100 according to the above embodiments. A further description of the structure of the battery pack 100 is omitted here. As shown in FIG. 39, the vehicle body 200 has a passenger space 220 formed in the vehicle body 200, and the battery pack 100 is mounted at a bottom of the vehicle body 200. By adopting the above battery pack 100, it is possible to protect the internal structure of the vehicle 1000, improve the integrated design of the battery pack 100 and the vehicle 1000, reduce the number of parts, and reduce the cost and weight. In an embodiment of the present disclosure, the battery pack 100 is mounted at the bottom of the vehicle body 200. The vehicle body 200 further has an upwardly recessed cavity 240 at the bottom of the vehicle body 200, and the rear end of the battery pack 100 is arranged facing the upwardly recessed cavity 240. In this way, during maintenance, the first electrical portion 32 in the side access opening 101 can be maintained through the upwardly recessed cavity 240 from below, eliminating the need to disassemble the entire vehicle, resulting in less damage to the vehicle. Other arrangements and operations of the vehicle 1000 according to the embodiments of the present disclosure are known to those of ordinary skill in the art, and the description thereof in detail will be omitted herein.

In the description of this specification, descriptions with reference to "an embodiment", "an example", or the like mean that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Moreover, the particular features, structures, materials, or characteristics described may be combined in any suitable manner in one or more embodiments or examples. Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. A battery pack (100), **characterized by** comprising:
a frame (10) configured to enclose a receiving cavity (V1);
a partition assembly (5) disposed in the frame (10) to divide the receiving cavity (V1) into a plurality of receiving sub-cavities (V10);
a liquid cooling plate (6) located at a bottom of the frame (10), wherein the liquid cooling plate (6) has a bottom access opening (61) directly facing one of the plurality of receiving sub-cavities (V10), the liquid cooling plate (6) being fixedly connected to the frame (10) and at least part of the partition assembly (5) adjacent to the bottom access opening (61); and
a bottom protection plate (15) detachably connected below the liquid cooling plate (6), the bottom protection plate (15) being configured to open and close the bottom access opening (61).

2. The battery pack (100) according to claim 1, wherein:
the partition assembly (5) comprises partition cross beams (51) extending in a left-right direction, the plurality of receiving sub-cavities (V10) comprising a front sub-cavity (V11) located at a side of one of the partition cross beams (51), and the bottom access opening (61) being located in the front sub-cavity (V11); and
the liquid cooling plate (6) has a plurality of first liquid cooling connection holes (6-07), at least part of the plurality of first liquid cooling connection holes (6-07) directly facing the partition cross beams (51), and the liquid cooling plate (6) being fixedly connected to the partition cross beams (51) through the at least part of the plurality of first liquid cooling connection holes (6-07).

3. The battery pack (100) according to claim 2, wherein the liquid cooling plate (6) has a plurality of first liquid cooling avoidance holes (6-09) arranged around the bottom access opening (61), wherein:
at least part of the plurality of first liquid cooling avoidance holes (6-09) directly faces one of the partition cross beams (51) at a side of the front sub-cavity (V11), the bottom protection plate (15) being detachably connected to the partition cross beam (51) through the at least part of the plurality of first liquid cooling avoidance holes (6-09).

4. The battery pack (100) according to claim 1, wherein:
the frame (10) has a front side wall (11); and
the partition assembly (5) comprises a partition longitudinal beam (52) extending in a front-rear direction and at least two partition cross beams (51), wherein each of the at least two partition cross beams (51) extends in a left-right direction, and two adjacent partition cross beams (51) of the at least two partition cross beams (51) are spaced apart from each other in the front-rear direction, wherein the partition longitudinal beam (52) is connected between every two adjacent partition cross beams (51) of the at least two partition cross beams (51) to divide a space between the two adjacent partition cross beams (51) into two receiving sub-cavities (V10) of the plurality of receiving sub-cavities (V10),
wherein a front sub-cavity (V11) is defined between a foremost partition cross beam (51) of the at least two partition cross beams (51) and the front side wall (11), the bottom access opening (61), a liquid inlet (6-02) and a liquid outlet (6-03) of the liquid cooling plate (6) being each located in the front sub-cavity (V11).

5. The battery pack (100) according to claim 4, wherein the liquid cooling plate (6) has a plurality of first liquid cooling connection holes (6-07) configured to fixedly connect the liquid cooling plate (6) to the partition assembly (5) and a plurality of second liquid cooling connection holes (6-08) configured to fixedly connect the liquid cooling plate (6) to the frame (10), wherein a part of the plurality of first liquid cooling connection holes (6-07) directly faces the at least two partition cross beams (51), and another part of the plurality of first liquid cooling connection holes (6-07) directly faces the partition longitudinal beam (52), and wherein the plurality of second liquid cooling connection holes (6-08) are arranged along an edge of the liquid cooling plate (6).

6. The battery pack (100) according to claim 5, wherein the liquid cooling plate (6) has a plurality of first liquid cooling avoidance holes (6-09) arranged around the bottom access opening (61) and a plurality of second liquid cooling avoidance holes (6-10) arranged along the edge of the liquid cooling plate (6), the bottom protection plate (15) being detachably connected above the liquid cooling plate (6) through the plurality of first liquid cooling avoidance holes (6-09) and the plurality of second liquid cooling avoidance holes (6-10).

7. The battery pack (100) according to any one of claims 4 to 6, wherein the liquid cooling plate (6) has a liquid flow channel (6-01) formed in the liquid cooling plate (6), the liquid flow channel (6-01) comprising:
two branching sub-channels (6-11) located at two sides of the partition longitudinal beam (52), an end of each of the two branching sub-channels (6-11) being located in the front sub-cavity (V11) and connected to the liquid inlet (6-02); and
a plurality of heat dissipation sub-channels (6-13) located at the two sides of the partition longitudinal beam (52), wherein each of the plurality of heat dissipation sub-channels (6-13) is connected to a branching sub-channel (6-11) of the two branching sub-channels (6-11) adjacent to the heat dissipation sub-channel (6-13) and corresponds to one of the plurality of receiving sub-cavities (V10).

8. The battery pack (100) according to claim 7, wherein the liquid flow channel (6-01) further comprises:
two return sub-channels (6-12) located at the two sides of the partition longitudinal beam (52), wherein an end of each of the two return sub-channels (6-12) located in the front sub-cavity (V11) is connected to the liquid outlet (6-03).

9. The battery pack (100) according to claim 8, wherein:
the frame (10) has a left side wall (13) and a right side wall (14); and
a battery group (2) of the battery pack (100) comprises a plurality of battery sub-groups (20), the plurality of battery sub-groups (20) being distributed in the receiving sub-cavities (V10) between two adjacent partition cross beams (51) of the at least two partition cross beams (51), wherein:
a left battery sub-group (20) of the plurality of battery sub-groups (20) is spaced apart from the left side wall (13) to form a flow passage (V101), and a right battery sub-group (20) of the plurality of battery sub-groups (20) is spaced apart from the right side wall (14) to form a further flow passage (V101); and
the two return sub-channels (6-12) are located directly below the two flow passages (V101).

10. The battery pack (100) according to any one of claims 1 to 9, wherein:
a front side wall (11) of the frame (10) is located adjacent to the bottom access opening (61); and
the battery pack (100) further comprises:
a high-voltage electrical terminal (315) and a low-voltage electrical terminal (316) that are mounted at the front side wall (11); and
two liquid cooling connectors (602) connected to a liquid inlet (6-02) and a liquid outlet (6-03) of the liquid cooling plate (6) through a liquid cooling pipe (601), the two liquid cooling connectors (602) being mounted at the front side wall (11).

11. The battery pack (100) according to any one of claims 1 to 10, wherein:
the frame (10) has a rear side wall (12), a rear sub-cavity (V12) being defined in the frame (10) between the partition assembly (5) and the rear side wall (12); and
an electrical module (3) of the battery pack (100) comprises a first electrical portion (32) mounted in the rear sub-cavity (V12) and a second electrical portion (33) located above the bottom access opening (61), wherein the rear side wall (12) has a side access opening (101) directly facing the first electrical portion (32).

12. A vehicle (1000), comprising the battery pack (100) according to any one of claims 1 to 11.
